(19) Europäisches Patentamt
European Patent Office
Office européen des brevets

(11) **EP 4 050 384 A1**

(12) **EUROPEAN PATENT APPLICATION**
published in accordance with Art. 153(4) EPC

(43) Date of publication:
**31.08.2022 Bulletin 2022/35**

(21) Application number: **20892570.1**

(22) Date of filing: **24.11.2020**

(51) International Patent Classification (IPC):
*G02B 5/20* (2006.01)  *G09F 9/00* (2006.01)
*G09F 9/30* (2006.01)  *G09F 9/302* (2006.01)
*G09F 9/33* (2006.01)  *H01L 27/32* (2006.01)
*H04N 9/30* (2006.01)  *H05B 33/12* (2006.01)
*H01L 51/50* (2006.01)  *H05B 33/14* (2006.01)

(52) Cooperative Patent Classification (CPC):
**G02B 5/20; G09F 9/00; G09F 9/30; G09F 9/302;
G09F 9/33; H01L 27/32; H01L 51/50; H04N 9/30;
H05B 33/12; H05B 33/14**

(86) International application number:
**PCT/JP2020/043558**

(87) International publication number:
**WO 2021/106823 (03.06.2021 Gazette 2021/22)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **29.11.2019 JP 2019216772
25.09.2020 JP 2020161443**

(71) Applicant: **Canon Kabushiki Kaisha
Ohta-ku
Tokyo 146-8501 (JP)**

(72) Inventor: **FUKAYA Youichi
Tokyo 146-8501 (JP)**

(74) Representative: **WESER & Kollegen
Patentanwälte PartmbB
Radeckestraße 43
81245 München (DE)**

(54) **DISPLAY DEVICE AND APPARATUS**

(57)    A display device is provided in which a plurality of display units include a first type unit and a second type unit, a peak wavelength of the first type unit is a first wavelength in a range of greater than or equal to 650 nm and less than or equal to 700 nm, and a peak wavelength of the second type unit is a second wavelength in a range of greater than or equal to 520 nm and less than 650 nm.

FIG. 4

**Description**

Technical Field

The present invention relates to a display device.

Background Art

Color vision that many humans have is referred to as normal color vision. Color vision that a few humans have, and that differs from normal color vision, is referred to as abnormal color vision. People with abnormal color vision (colorblind people) are said to be at least 1% (e.g., about 3%) of the world's population. It is not always easy for colorblind people to distinguish colors.
Patent Literature 1 discloses an image display device that reduces variation in color perception among individuals with different color matching functions.
Patent Literature 2 discloses an electronic watermark information display device that provides electronic watermark display to prevent unauthorized copies from being made by taking an image again.

Citation List

Patent Literature

PTL 1: Japanese Patent Laid-Open No. 2014-174361

PTL 2: Japanese Patent Laid-Open No. 2003-304508

Summary of Invention

Technical Problem

The image display device disclosed in Patent Literature 1 and the information display device disclosed in Patent Literature 2 are not thoroughly thought out about allowing colorblind people to easily distinguish colors. Accordingly, an object of the present invention is to provide a display device that allows a colorblind person to easily distinguish colors.

Solution to Problem

A first aspect of the present disclosure is a display device configured to perform display in a plurality of display units by using a light source. In the display device, the plurality of display units include a first type unit and a second type unit, a peak wavelength of the first type unit is a first wavelength in a range of greater than or equal to 650 nm and less than or equal to 700 nm, a peak wavelength of the second type unit is a second wavelength in a range of greater than or equal to 520 nm and less than 650 nm, and the first type unit and the second type unit exhibit a luminance of greater than or equal to 0.04 cd/m$^2$.
A second aspect of the present disclosure is a display device configured to perform display in a plurality of display units by using an electroluminescent light source. In the display device, the plurality of display units include a first type unit and a second type unit, the first type unit exhibits a maximum luminance at a first wavelength in a range of greater than or equal to 650 nm and less than or equal to 700 nm, the second type unit exhibits a maximum luminance at a second wavelength in a range of greater than or equal to 500 nm and less than 600 nm, and a highest spectral radiance of the first type unit at the first wavelength is higher than a highest spectral radiance of the second type unit at the second wavelength.
A third aspect of the present disclosure is a display device configured to perform display in a plurality of display units by using a light source. In the display device, the plurality of display units include a first type unit and a second type unit having different structures; the first type unit exhibits a maximum luminance at a first wavelength in a range of greater than or equal to 650 nm and less than or equal to 700 nm; the second type unit exhibits a maximum luminance at a second wavelength in a range of greater than or equal to 480 nm and less than 650 nm; the first type unit exhibits a spectral radiance of greater than or equal to $1/(683*V(\lambda L))$ [W/sr/m$^2$/nm] at the first wavelength, where $\lambda L$ [nm] is the first wavelength and $V(\lambda L)$ is a standard spectral luminous efficiency for photopic vision at the first wavelength; and the second type unit exhibits a spectral radiance of greater than or equal to $5/(683*V(\lambda 3))$ [W/sr/m$^2$/nm] at the second wavelength, where λS [nm] is the second wavelength and V(λS) is a standard spectral luminous efficiency for photopic vision at the second wavelength.

Advantageous Effects of Invention

The present invention can provide a display device that allows a colorblind person to easily distinguish colors.

Brief Description of Drawings

[Fig. 1A] Fig. 1A is a schematic diagram for explaining a display device and an apparatus.
[Fig. 1B] Fig. 1B is a schematic diagram for explaining the display device and the apparatus.
[Fig. 1C] Fig. 1C is a schematic diagram for explaining the display device and the apparatus.
[Fig. 2A] Fig. 2A is a schematic diagram for explaining the display device.
[Fig. 2B] Fig. 2B is a schematic diagram for explaining the display device.
[Fig. 3A] Fig. 3A is a schematic diagram for explaining the display device and the apparatus.
[Fig. 3B] Fig. 3B is a schematic diagram for explaining the display device and the apparatus.
[Fig. 3C] Fig. 3C is a schematic diagram for explaining the display device and the apparatus.
[Fig. 3D] Fig. 3D is a schematic diagram for explaining the display device and the apparatus.
[Fig. 4] Fig. 4 is a schematic diagram for explaining the display device.
[Fig. 5A] Fig. 5A is a schematic diagram for explaining the display device.
[Fig. 5B] Fig. 5B is a schematic diagram for explaining the display device.
[Fig. 5C] Fig. 5C is a schematic diagram for explaining the display device.
[Fig. 5D] Fig. 5D is a schematic diagram for explaining the display device.
[Fig. 5E] Fig. 5E is a schematic diagram for explaining the display device.
[Fig. 6A] Fig. 6A is a schematic diagram for explaining the display device.
[Fig. 6B] Fig. 6B is a schematic diagram for explaining the display device.
[Fig. 6C] Fig. 6C is a schematic diagram for explaining the display device.
[Fig. 7] Fig. 7 is a schematic diagram for explaining the display device.
[Fig. 8] Fig. 8 is a schematic diagram for explaining the display device.
[Fig. 9A] Fig. 9A is a schematic diagram for explaining the display device.
[Fig. 9B] Fig. 9B is a schematic diagram for explaining the display device.
[Fig. 9C] Fig. 9C is a schematic diagram for explaining the display device.
[Fig. 9D] Fig. 9D is a schematic diagram for explaining the display device.
[Fig. 9E] Fig. 9E is a schematic diagram for explaining the display device.
[Fig. 9F] Fig. 9F is a schematic diagram for explaining the display device.
[Fig. 10] Fig. 10 is a schematic diagram for explaining the display device.
[Fig. 11A] Fig. 11A is a schematic diagram for explaining the display device.
[Fig. 11B] Fig. 11B is a schematic diagram for explaining the display device.
[Fig. 11C] Fig. 11C is a schematic diagram for explaining the display device.
[Fig. 11D] Fig. 11D is a schematic diagram for explaining the display device.
[Fig. 11E] Fig. 11E is a schematic diagram for explaining the display device.
[Fig. 11F] Fig. 11F is a schematic diagram for explaining the display device.
[Fig. 11G] Fig. 11G is a schematic diagram for explaining the display device.
[Fig. 11H] Fig. 11H is a schematic diagram for explaining the display device.
[Fig. 12A] Fig. 12A is a schematic diagram for explaining human vision.
[Fig. 12B] Fig. 12B is a schematic diagram for explaining human vision.
[Fig. 12C] Fig. 12C is a schematic diagram for explaining human vision.
[Fig. 12D] Fig. 12D is a schematic diagram for explaining human vision.
[Fig. 13A] Fig. 13A is a schematic diagram for explaining the display device.
[Fig. 13B] Fig. 13B is a schematic diagram for explaining the display device.

Description of Embodiments

Hereinafter, embodiments of the present invention will be described with reference to the drawings. In the following description and drawings, the same components appearing in a plurality of drawings are denoted by the same reference numerals. The same components will therefore be described by cross-reference to the plurality of drawings, and the description of the components denoted by the same reference numerals will be omitted where appropriate.

<First Embodiment>

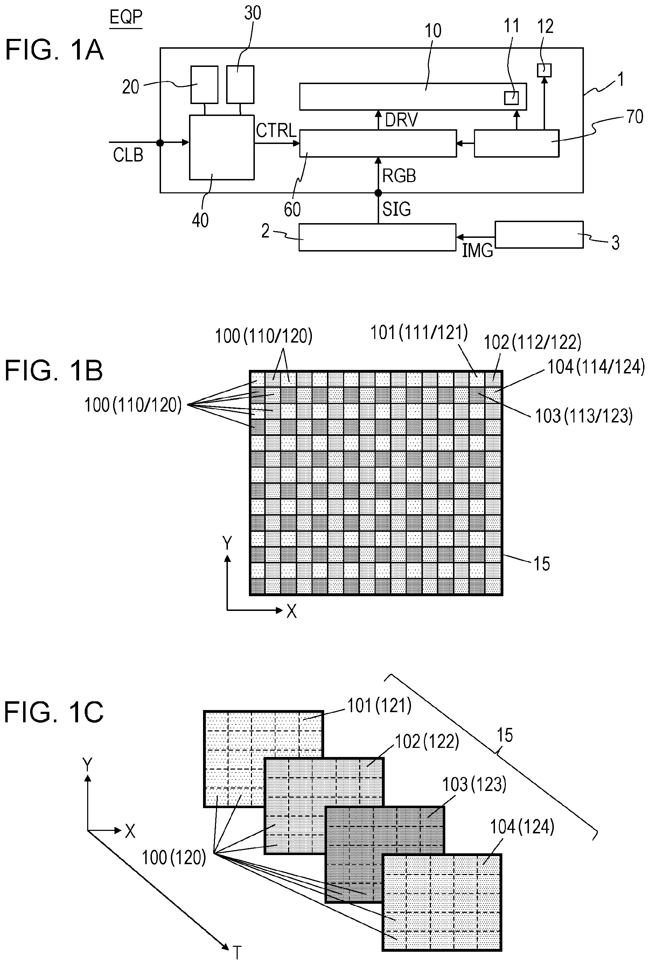

Fig. 1A illustrates an example of an apparatus EQP that includes a display device 1. The display device 1 includes an element unit 10 for performing display. The display device 1 includes at least one of a light source 11 and a light source 12. The light source 11 and the light source 12 are used to perform display intended by the display device 1. The light source 11 constitutes a part of the element unit 10. The light source 12 is a component separate from the element unit 10. For example, the light source 12 does not need to be provided when the element unit 10 includes the light source 11. For example, the light source 12 is provided when the element unit 10 does not include the light source 11.

The display device 1 may include a drive unit 60 that sends a drive signal DRV to the element unit 10. The display device 1 may include a power supply unit 70 that supplies power to the element unit 10 and the drive unit 60. The display device 1 may include a controller 40 that sends a control signal CTRL for controlling the drive unit 60. The apparatus EQP including the display device 1 may include a signal generating device 2 that sends an image signal SIG to the display device 1. The apparatus EQP may include an information generating device 3 that generates image information IMG on which the image signal SIG generated by the signal generating device 2 is based. The signal generating device 2 may include, for example, a computing unit, such as a graphics processing unit (GPU). The information generating device 3 may include, for example, a computing unit, such as a central processing unit (CPU). The devices 1, 2, and 3 may each include a memory unit where appropriate. The configuration of the display device 1 and the apparatus EQP is not limited to this. Some components may be removed or other components may be added.

Fig. 1B schematically illustrates an image 15 displayed by the element unit 10 and/or the display device 1. The element unit 10 includes a plurality of elements 110. The plurality of elements 110 may include a type α element 111 and a type β element 112. The plurality of elements 110 may also include a type γ element 113 and a type δ element 114. The plurality of elements 110 include four types of elements in this example, and may include at least two types of elements. The plurality of elements 110 may include a type ε element (not shown), as well as the four types of elements 111, 112, 113, and 114. The plurality of elements 110 may include five or more types of elements 110.

As illustrated in Fig. 1B and Fig. 1C, the image 15 displayed by the display device 1 includes a plurality of pixels 120. The plurality of pixels 120 may include a type α pixel 121 and a type β pixel 122. The plurality of pixels 120 may also include a type γ pixel 123 and a type δ pixel 124. The plurality of pixels 120 may include at least two types of pixels. The plurality of pixels 120 include four types of pixels in this example. The plurality of pixels 120 may include a type ε pixel (not shown), as well as the four types of pixels 121, 122, 123, and 124. The plurality of pixels 120 may include five or more types of pixels 120. The image 15 illustrated in Fig. 1B includes a plurality of types of pixels 120 in one screen. On the other hand, the image 15 illustrated in Fig. 1C is constituted by a plurality of screens, each having pixels 120 of the same type alone.

The element 110 and the pixel 120 may be collectively referred to as a display unit 100. That is, a plurality of display units 100 are a plurality of elements 110 and/or a plurality of pixels 120. For example, one display unit 100 is one of the plurality of elements 110. For example, one display unit 100 is one of the plurality of pixels 120. Of the plurality of display units 100, a type α unit 101 is the type α element 111 and/or the type α pixel 121. Of the plurality of display units 100, a type β unit 102 is the type β element 112 and/or the type β pixel 122. Of the plurality of display units 100, a type γ unit 103 is the type γ element 113 and/or the type γ pixel 123. Of the plurality of display units 100, a type δ unit 104 is the type δ element 114 and/or the type α pixel 124. Of the plurality of display units 100, a type ε unit is the type ε element and/or the type ε pixel.

The display units 100 and the elements 110 and/or pixels 120 are categorized into different types by the wavelength of exhibited light. Light exhibited by the display units 100 of each type has a predetermined spectral characteristic.

First, a spectral radiance characteristic will be described. The spectral radiance characteristic is a relation between the wavelength and the spectral radiance, and the spectral radiance with respect to any wavelength $\lambda$ serving as a variable is defined by a function $L(\lambda)$ of the wavelength $\lambda$ [nm]. For example, the display unit 100 exhibits a predetermined spectral radiance $L(A)$ at a specific wavelength A ($\lambda = A$). Since the spectral radiance is a radiant quantity per specific wavelength, the unit of the spectral radiance $L(\lambda)$ is [W/sr/m$^2$/nm] . The unit of the spectral radiance $L(\lambda)$ may be abbreviated as [W/sr/m$^2$]. The display unit 100 may also exhibit light of a wavelength different from the specific wavelength A, and light exhibited by the display unit 100 may include light of a plurality of wavelengths in a predetermined wavelength band from a wavelength $\lambda$min to a wavelength $\lambda$max. In this case, the total radiance of the light of all wavelengths in the predetermined wavelength band, exhibited by the display unit 100, is referred to as integrated radiance Le. The unit of the integrated radiance Le is [W/sr/m$^2$] . The integrated radiance Le is typically referred to as "radiance", but is referred to as integrated radiance in the following description, in distinction from the spectral radiance $L(\lambda)$. The relation between the integrated radiance Le and the spectral radiance $L(\lambda)$ is given by equation (1) below.
[Math. 1]

$$Le = \int_{\lambda=\lambda min}^{\lambda=\lambda max} L(\lambda)d\lambda \quad \cdots \quad (1)$$

The wavelength band for determining the integrated radiance Le is specifically a visible light range, and λmin is from 360 nm to 380 nm and λmax is from 750 nm to 830 nm. When the predetermined wavelength band is from 360 nm to 830 nm, the relation between the integrated radiance Le and the spectral radiance L(λ) is given, for example, by equation (2) below.
[Math. 2]

$$Le = \int_{\lambda=360nm}^{\lambda=830nm} L(\lambda)d\lambda \quad \cdots \quad (2)$$

An integrated photometric luminance Lv exhibited by the display unit 100 will now be described. The integrated photometric luminance Lv is a photometric quantity obtained by assigning the weight of the impact of radiation of light in the visible light range on human vision to the integrated radiance Le defined as a radiant quantity. The photometric quantity is expressed by multiplying the radiant quantity by a spectral luminous efficiency and integrating the resulting values over the wavelength range from the wavelength λmin to the wavelength λmax. The unit of the integrated photometric luminance Lv is "cd/m$^2$" or "nt", or may be expressed as "lm/sr/m$^2$". The integrated photometric luminance Lv is typically referred to as "luminance", but is referred to as the integrated photometric luminance Lv in the following description, in distinction from the spectral radiance L(λ) or the integrated radiance Le. The relation between the integrated photometric luminance Lv and the spectral radiance L(λ)is given by equation (3) below.
[Math. 3]

$$Lv = Km * \int_{\lambda=\lambda min}^{\lambda=\lambda max} L(\lambda) * V(\lambda)d\lambda \quad \cdots \quad (3)$$

Note that V(λ) is a standard spectral luminous efficiency for photopic vision and a function of the wavelength λ. V(λ) has a value greater than or equal to 0 and less than or equal to 1. The standard spectral luminous efficiency V(λ) is also referred to as a standard relative luminosity. Km is a maximum luminous efficacy and a value (Km = 683 [lm/W]) that associates the photometric quantity with the radiant quantity at a wavelength (λ = 555 nm) where V (λ) = 1. The wavelength band for determining the integrated photometric luminance Lv is specifically a visible light range, the wavelength band for determining the integrated photometric luminance Lv is specifically a visible light range, and λmin is from 360 nm to 380 nm and λmax is from 750 nm to 830 nm. When the predetermined wavelength band is from 360 nm to 830 nm, the relation between the integrated photometric luminance Lv and the spectral radiance L(λ) is given by equation (4) below.
[Math. 4]

$$Lv = 683 * \int_{\lambda=360nm}^{\lambda=830nm} L(\lambda) * V(\lambda)d\lambda \quad \cdots \quad (4)$$

A spectral photometric luminance characteristic exhibited by the display unit 100 will now be described. The spectral photometric luminance characteristic is a relation between the wavelength and the spectral photometric luminance, and the spectral photometric luminance with respect to any wavelength λ serving as a variable is defined by a function F(λ) of the wavelength λ. The display unit 100 exhibits a predetermined spectral photometric luminance F(A) at a specific wavelength A (λ = A). The spectral photometric luminance F(λ) is a physical quantity obtained by assigning the weight of the impact of radiation of light in the visible light range on human vision to the spectral radiance L(λ) defined as a radiant quantity. Since the spectral photometric luminance is a photometric quantity per specific wavelength, the unit of the spectral photometric luminance F(λ) is [cd/m$^2$/nm] . The unit of the spectral photometric luminance F(λ) may be abbreviated as [cd/m$^2$] . When the unit [cd/m$^2$] is used in association with a specific wavelength in the following description, the unit [cd/m$^2$] used to express the spectral photometric luminance may be read as [cd/m$^2$/nm] on the assumption that the unit [cd/m$^2$] is used to express the spectral photometric luminance. On the other hand, when the unit [cd/m$^2$] is used in the following description, if the unit [cd/m$^2$] is used to express the integrated photometric luminance, it will be described accordingly. The relation between the spectral photometric luminance F(λ) and the spectral radiance L(λ) is given by equation (5) below.

$$F(\lambda) = 683*L(\lambda)*V(\lambda) \quad \cdots \quad (5)$$

As can be seen from equations (3) and (4) and equation (5), the spectral photometric luminance $F(\lambda)$ is an indefinite integral of the spectral radiance $L(\lambda)$.

When the display unit 100 having a predetermined spectral characteristic exhibits the spectral radiance L(A) at the wavelength A, the integrated radiance Le of the display unit 100 is greater than or equal to the spectral radiance L(A) (Le $\geq$ L(A)). That is, exhibiting the spectral radiance L(A) or greater at the wavelength A is a sufficient condition that the integrated radiance Le of the display unit 100 is greater than or equal to L(A). The relation Le = L(A) is satisfied when the spectral radiance $L(\lambda)$ = 0 holds true for all the wavelengths except the wavelength A, that is, when the display unit 100 exhibits light of only a single wavelength. When the display unit 100 having a predetermined spectral characteristic exhibits the spectral photometric luminance F(A) at the wavelength A, the integrated photometric luminance Lv of the display unit 100 is greater than or equal to the spectral photometric luminance F(A) (Lv $\geq$ F($\Lambda$)). That is, exhibiting the spectral photometric luminance F(A) or greater at the wavelength A is a sufficient condition that the integrated photometric luminance Lv of the display unit 100 is greater than or equal to F($\Lambda$). The relation Lv = F(A) is satisfied when the spectral photometric luminance $F(\lambda)$ = 0 holds true for all wavelengths except the wavelength A, that is, when the display unit 100 exhibits light of only a single wavelength.

In the light of the description above, when the spectral radiance L(A) is exhibited at the wavelength A, it can be seen from equation (5) that the integrated photometric luminance Lv of the display unit 100 is greater than or equal to 683*L($\Lambda$)*V($\Lambda$) (Lv $\geq$ 683*L($\Lambda$)*V($\Lambda$)). That is, exhibiting the spectral radiance L(A) or greater at the wavelength A is a sufficient condition that the integrated photometric luminance Lv of the display unit 100 is greater than or equal to 683*L($\Lambda$)*V($\Lambda$).

When the spectral photometric luminance $F(\lambda)$ is exhibited at the wavelength $\lambda$, the spectral radiance $L(\lambda)$ at the wavelength $\lambda$ can be determined by the following equation (6) obtained by modifying equation (5). By thus using equation (5) or equation (6), the spectral radiance $L(\lambda)$ and the spectral photometric luminance $F(\lambda)$ can be converted to each other. When the spectral photometric luminance $F(\lambda)$ is described by using the unit [cd/m$^2$] or [cd/m$^2$/nm] in the following description, the spectral photometric luminance $F(\lambda)$ may be converted to the spectral radiance $L(\lambda)$ by using equation (5) or equation (6).

$$L(\lambda) = F(\lambda)/(683*V(\lambda)) \quad \cdots \quad (6)$$

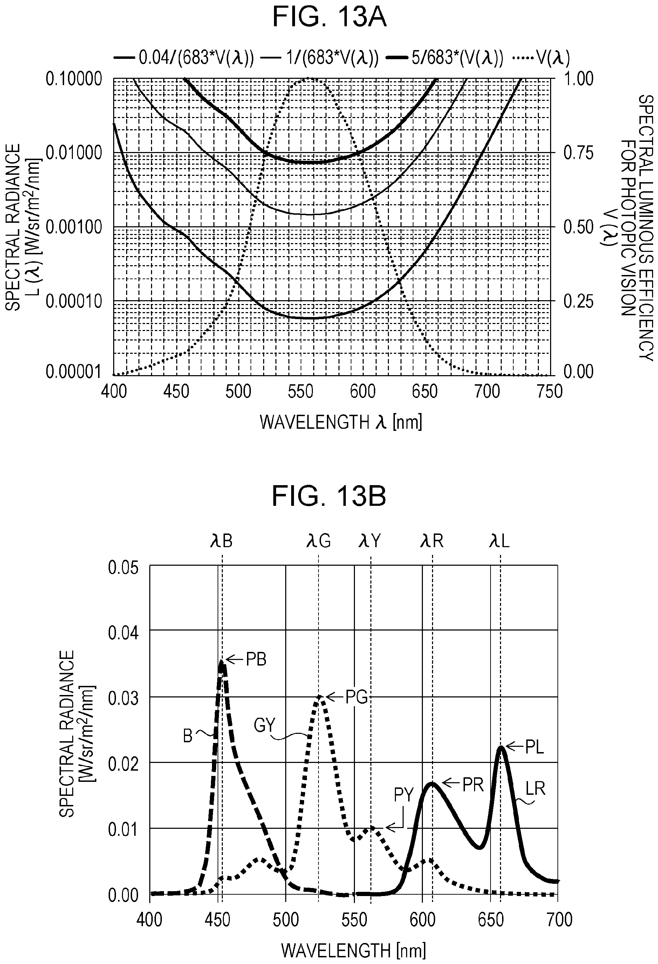

To achieve the integrated photometric luminance Lv greater than or equal to F(A) [cd/m$^2$] with light of the single wavelength A [nm] alone, the spectral radiance L(A) at the wavelength A [nm] needs to be greater than or equal to F($\Lambda$)/(683*V($\Lambda$)) [W/sr/m$^2$/nm] . In other words, when spectral radiance at the wavelength A [nm] is greater than or equal to F($\Lambda$)/(683*V($\Lambda$)) [W/sr/m$^2$/nm] , the integrated photometric luminance Lv greater than or equal to F(A) [cd/m$^2$] can be achieved regardless of whether the light is of single wavelength. Referring to the graph of Fig. 13A, the horizontal axis represents the wavelength $\lambda$. The vertical axis on the right side of the graph of Fig. 13A (linear axis) represents the standard spectral luminous efficiency $V(\lambda)$ for photopic vision. The vertical axis on the left side of the graph of Fig. 13A (logarithmic axis) represents the spectral radiance $L(\lambda)$. The graph of Fig. 13A shows the spectral radiance $L(\lambda)$ = 0.04/(683*V($\lambda$)) obtained by substituting the spectral photometric luminance $F(\lambda)$ = 0.04 cd/m$^2$ into equation (6). Similarly, the graph of Fig. 13A shows the spectral radiance $L(\lambda)$ = 1/(683*V($\lambda$)) obtained by substituting the spectral photometric luminance $F(\lambda)$ = 1 cd/m$^2$ into equation (6), and the spectral radiance $L(\lambda)$ = 5/(683*V($\lambda$)) obtained by substituting the spectral photometric luminance $F(\lambda)$ = 5 cd/m$^2$ into equation (6).

For example, the standard spectral luminous efficiency $V(\lambda)$ at a wavelength of 600 nm is 0.69. Substituting $F(\lambda)$ = 5 and $V(\lambda)$ = 0.69 into equation (6) yields 5/(683*0.69) $\approx$ 0.011. Accordingly, to achieve the integrated photometric luminance Lv greater than or equal to 5 cd/m$^2$ with light of a single wavelength of 600 nm alone, the spectral radiance at a wavelength of 600 nm needs to be greater than or equal to 0.011 W/sr/m$^2$/nm. In other words, if the spectral radiance at a wavelength of 600 nm is simply greater than or equal to 0.011 W/sr/m$^2$/nm, the integrated photometric luminance Lv greater than or equal to 5 cd/m$^2$ can be achieved regardless of whether the light is of single wavelength. Also, for example, the standard spectral luminous efficiency $V(\lambda)$ at a wavelength of 650 nm is 0.12. Substituting $F(\lambda)$ = 1 and $V(\lambda)$ = 0.12 into equation (6) yields 1/(683*0.12) $\approx$ 0.0123. To achieve the integrated photometric luminance Lv greater than or equal to 1 cd/m$^2$ with light of a single wavelength of 650 nm alone, the spectral radiance at a wavelength of 650 nm needs to be greater than or equal to 0.0123 W/sr/m$^2$/nm. In other words, if the spectral radiance at a wavelength of 650 nm is simply greater than or equal to 0.0123 W/sr/m$^2$/nm, the integrated photometric luminance Lv greater than or equal to 1 cd/m$^2$ can be achieved regardless of whether the light is of single wavelength. Also, for example, the standard spectral luminous efficiency $V(\lambda)$ at a wavelength of 700 nm is 0.0042. Substituting $F(\lambda)$ = 0.04 and $V(\lambda)$ = 0.0042 into equation (6) yields 0.04/(683*0.0042) $\approx$ 0.014. To achieve the integrated photometric luminance Lv greater than or equal to 0.04 cd/m$^2$ with light of a single wavelength of 700 nm alone, the spectral radiance at a wavelength of 700 nm needs to be greater than or equal to 0.014 W/sr/m$^2$/nm. In other words, if the spectral radiance at a wavelength of 700 nm is simply greater than or equal to 0.014 W/sr/m$^2$/nm, the integrated photometric luminance Lv greater than or equal to 0.04 cd/m$^2$ can be achieved regardless of whether the light is of single wavelength.

Similarly, if the spectral radiance at a wavelength of 520 nm is greater than or equal to 0.0001 W/sr/m$^2$/nm, the integrated photometric luminance Lv greater than or equal to 0.04 cd/m$^2$ can be achieved. If the spectral radiance at a wavelength of 600 nm is greater than or equal to 0.0001 W/sr/m$^2$/nm, the integrated photometric luminance Lv greater than or equal to 0.04 cd/m$^2$ can be achieved. If the spectral radiance at a wavelength of 650 nm is greater than or equal to 0.0005 W/sr/m$^2$/nm, the integrated photometric luminance Lv greater than or equal to 0.04 cd/m$^2$ can be achieved. Also, if the spectral radiance at a wavelength of 480 nm is greater than or equal to 0.082 W/sr/m$^2$/nm, the integrated photometric luminance Lv greater than or equal to 1 cd/m$^2$ can be achieved. If the spectral radiance at a wavelength of 600 nm is greater than or equal to 0.0021 W/sr/m$^2$/nm, the integrated photometric luminance Lv greater than or equal to 1 cd/m$^2$ can be achieved. If the spectral radiance at a wavelength of 700 nm is greater than or equal to 0.3489 W/sr/m$^2$/nm, the integrated photometric luminance Lv greater than or equal to 1 cd/m$^2$ can be achieved. If the spectral radiance at a wavelength of 480 nm is greater than or equal to 0.041 W/sr/m$^2$/nm, the integrated photometric luminance Lv greater than or equal to 5 cd/m$^2$ can be achieved. If the spectral radiance at a wavelength of 520 nm is greater than or equal to 0.010 W/sr/m$^2$/nm, the integrated photometric luminance Lv greater than or equal to 5 cd/m$^2$ can be achieved. If the spectral radiance at a wavelength of 650 nm is greater than or equal to 0.061 W/sr/m$^2$/nm, the integrated photometric luminance Lv greater than or equal to 5 cd/m$^2$ can be achieved.

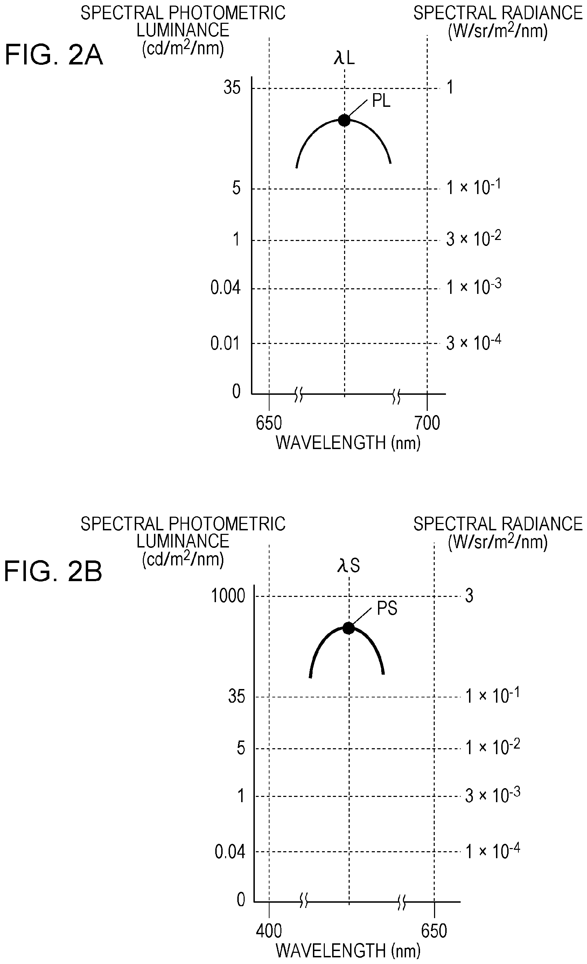

Fig. 2A shows a spectral characteristic L of the luminance of light exhibited by the type $\alpha$ unit 101 (type $\alpha$ element 111 and/or type $\alpha$ pixel 121). The type $\alpha$ unit 101 exhibits a maximum luminance PL greater than or equal to 0.04 cd/m$^2$ at a wavelength $\lambda$L in a range of greater than or equal to 650 nm and less than or equal to 700 nm. That is, the wavelength-luminance characteristic (spectral luminance characteristic) of the type $\alpha$ unit 101 is characterized in that the luminance monotonously increases as the wavelength increases from the wavelength $\lambda$L-$\Delta\lambda$ toward the wavelength $\lambda$L, whereas the luminance monotonously decreases as the wavelength increases from the wavelength $\lambda$L toward the wavelength $\lambda$L+$\Delta\lambda$. When the wavelength is assumed to increase, the luminance on the rise starts to decrease at the wavelength $\lambda$L. Note that since luminance at a wavelength outside the vicinity of the wavelength $\lambda$L may be any value, Fig. 2A only shows the spectral luminance characteristic at and around the wavelength $\lambda$L and does not show luminance at wavelengths outside the vicinity of the wavelength $\lambda$L.

In Fig. 2A, which shows a spectral luminance characteristic, the axis on the left gives the spectral luminance characteristic represented by spectral photometric luminance, and the axis on the right gives the spectral luminance characteristic represented by spectral radiance. Note that the standard spectral luminous efficiency V($\lambda$L) for photopic vision at the wavelength $\lambda$L in a range of greater than or equal to 650 nm and less than or equal to 700 nm is applicable to Fig. 2A when V($\lambda$L) = 0.05 is used as a typical example, but the value of the maximum luminance PL is applicable even when V($\lambda$L) is not 0.05.

The maximum luminance PL simply needs to be greater than or equal to 0.04 cd/m$^2$. In this case, the integrated photometric luminance of the type $\alpha$ unit 101 is greater than or equal to 0.04 cd/m$^2$. When the maximum luminance PL at the wavelength $\lambda$L is greater than or equal to 0.04 cd/m$^2$ in terms of spectral photometric luminance, the spectral radiance at the wavelength $\lambda$L is greater than or equal to 0.04/ (683*V ($\lambda$L) ) [W/sr/m$^2$/nm] . Although the maximum luminance PL may be less than 1 cd/m$^2$, it is preferable that the maximum luminance PL be greater than or equal to 1 cd/m$^2$. In this case, the integrated photometric luminance of the type $\alpha$ unit 101 is greater than or equal to 1 cd/m$^2$. When the maximum luminance PL at the wavelength $\lambda$L is greater than or equal to 1 cd/m$^2$ in terms of spectral photometric luminance, the spectral radiance at the wavelength $\lambda$L is greater than or equal to 1/(683*V($\lambda$L)) [W/sr/m$^2$/nm] . Although the maximum luminance PL may be less than 5 cd/m$^2$, it is preferable that the maximum luminance PL be greater than or equal to 5 cd/m$^2$. In this case, the integrated photometric luminance of the type $\alpha$ unit 101 is greater than or equal to 5 cd/m$^2$. When the maximum luminance PL at the wavelength $\lambda$L is greater than or equal to 5 cd/m$^2$ in terms of spectral photometric luminance, the spectral radiance at the wavelength $\lambda$L is greater than or equal to 5/(683*V($\lambda$L)) [W/sr/m$^2$/nm] . Although the maximum luminance PL may be less than 35 cd/m$^2$, the maximum luminance PL is more preferably greater than or equal to 35 cd/m$^2$. In this case, the integrated photometric luminance of the type $\alpha$ unit 101 is greater than or equal to 35 cd/m$^2$. Although the maximum luminance PL may be less than 100 cd/m$^2$, the maximum luminance PL is still more preferably greater than or equal to 100 cd/m$^2$. In this case, the integrated photometric luminance of the type $\alpha$ unit 101 is greater than or equal to 100 cd/m$^2$. Although the maximum luminance PL may be greater than or equal to 1000 cd/m$^2$, the maximum luminance PL may be less than 1000 cd/m$^2$. The integrated photometric luminance of the type $\alpha$ unit 101 may be less than 1000 cd/m$^2$ in terms of spectral photometric luminance. Although the maximum luminance PL may be greater than or equal to 500 cd/m$^2$, the maximum luminance PL may be less than 500 cd/m$^2$. The integrated photometric luminance of the type $\alpha$ unit 101 may be less than 500 cd/m$^2$ in terms of spectral photometric luminance. The type $\alpha$ unit 101 may exhibit the maximum luminance PL greater than or equal to 5 cd/m$^2$ at the wavelength $\lambda$L in a range of greater than or equal to 600 nm (preferably greater than or equal to 650 nm) and less than or equal to 700 nm. The maximum luminance PL may be a peak luminance exhibited by the type $\alpha$ unit 101. Here, the peak luminance is the highest value (maximum value) of luminance in the spectral characteristic of a given display unit 100. The maximum wavelength $\lambda$L may be a peak wavelength of the type $\alpha$ unit 101. Here, the peak wavelength is the wavelength of light exhibiting a peak luminance in the range (spectrum distribution) of light exhibited by the display unit 100 having a predetermined wavelength-luminance characteristic (spectral luminance characteristic). Accordingly, at wavelengths outside the peak wavelength, the display unit 100 has a luminance less than the peak luminance. The term "dominant wavelength" has a meaning different from "peak wavelength". The dominant wavelength is a wavelength corresponding to a color perceived when the eye actually sees light produced by combining light of a plurality of wavelengths in the range of light exhibited by the display unit 100 having a predetermined spectral luminance characteristic. That is, the dominant wavelength is determined in accordance with the spectrum distribution of light exhibited by the display unit 100. The peak wavelength may differ from the dominant wavelength with the same spectral luminance characteristic. The peak wavelength is associated with the spectrum distribution of a radiant quantity (spectral radiance $L(\lambda)$), and the dominant wavelength is associated with the spectrum distribution of a photometric quantity (spectral photometric luminance $F(\lambda)$). Accordingly, the peak wavelength and the peak luminance are defined by the spectrum distribution of spectral radiance. However, the peak luminance can be expressed by spectral radiance, and can also be expressed by spectral photometric luminance using equation (5) as described above.

Fig. 2B shows a spectral characteristic S of the luminance of light exhibited by the type $\beta$ unit 102 (type $\beta$ element 11 and/or type $\beta$ pixel 122). The type $\beta$ unit 102 exhibits a maximum luminance PS greater than or equal to 0.04 cd/m$^2$ at a wavelength $\lambda$S in a range of greater than or equal to 400 nm and less than 650 nm. That is, the wavelength-luminance characteristic of the type $\beta$ unit 102 is characterized in that the luminance monotonously increases as the wavelength increases from the wavelength $\lambda$S-$\Delta\lambda$ toward the wavelength $\lambda$S, whereas the luminance monotonously decreases as the wavelength increases from the wavelength $\lambda$S toward the wavelength $\lambda$S+$\Delta\lambda$. When the wavelength is assumed to increase, the luminance on the rise starts to decrease at the wavelength $\lambda$S. Note that since luminance at a wavelength outside the vicinity of the wavelength $\lambda$S may be any value, Fig. 2B only shows the spectral luminance characteristic at and around the wavelength $\lambda$S and does not show luminance at wavelengths outside the vicinity of the wavelength $\lambda$S.

In Fig. 2B, which shows a spectral luminance characteristic, the axis on the left gives the spectral luminance characteristic represented by spectral photometric luminance, and the axis on the right gives the spectral luminance characteristic represented by spectral radiance. Note that the standard spectral luminous efficiency $V(\lambda S)$ for photopic vision at the wavelength $\lambda$L in a range of greater than or equal to 400 nm and less than or equal to 650 nm is applicable to Fig. 2B when $V(\lambda S) = 0.5$ is used as a typical example, but the value of the maximum luminance PS is applicable even when $V(\lambda S)$ is not 0.5.

The maximum luminance PS simply needs to be greater than or equal to 0.04 cd/m$^2$. In this case, the integrated photometric luminance of the type $\beta$ unit 102 is greater than or equal to 0.04 cd/m$^2$. When the maximum luminance PS at the wavelength $\lambda$S is greater than or equal to 0.04 cd/m$^2$, the spectral radiance at the wavelength $\lambda$S is greater than or equal to 0.04/ (683*V ($\lambda$S) ) [W/sr/m$^2$/nm] . Although the maximum luminance PS may be less than 1 cd/m$^2$, it is preferable that the maximum luminance PS be greater than or equal to 1 cd/m$^2$. In this case, the integrated photometric luminance of the type $\beta$ unit 102 is greater than or equal to 1 cd/m$^2$. When the maximum luminance PS at the wavelength $\lambda$S is greater than or equal to 1 cd/m$^2$ in terms of spectral photometric luminance, the spectral radiance at the wavelength $\lambda$S is greater than or equal to 1/(683*V($\lambda$L)) [W/sr/m$^2$/nm] . Although the maximum luminance PS may be less than 5 cd/m$^2$, it is preferable that the maximum luminance PS be greater than or equal to 5 cd/m$^2$. In this case, the integrated photometric luminance of the type $\beta$ unit 102 is greater than or equal to 5 cd/m$^2$. When the maximum luminance PS at the wavelength $\lambda$S is greater than or equal to 5 cd/m$^2$, the spectral radiance at the wavelength $\lambda$S is greater than or equal to 5/(683*V($\lambda$S)) [W/sr/m$^2$/nm]. As can be understood from Fig. 13A, $V(\lambda = 468nm) = V(\lambda = 650 nm) = 0.12$ holds true. Accordingly, in a range of greater than or equal to 470 nm (or greater than or equal to 480 nm) and less than 650 nm, a spectral photometric luminance of greater than or equal to 5 cd/m$^2$ can be achieved by a spectral radiance of less than or equal to 0.06 W/sr/m$^2$/nm. It is not difficult to achieve a spectral radiance of less than or equal to 0.06 W/sr/m$^2$/nm by a light source, such as an electroluminescent, photoluminescent, or cathodoluminescent light source, typically used in display devices. Additionally, when $V(\lambda = 519 nm) = V(\lambda = 600 nm) = 0.69$ holds true and the wavelength is in a range of greater than or equal to 520 nm and less than 600 nm, a spectral photometric luminance of greater than or equal to 5 cd/m$^2$ can be achieved by a spectral radiance of less than or equal to 0.01 W/sr/m$^2$/nm. That is, for the type $\beta$ unit 102 to exhibit a high luminance, the wavelength $\lambda$S is preferably in a range of greater than or equal to 470 nm (or greater than or equal to 480 nm) and less than 650 nm, and more preferably in a range of greater than or equal to 520 nm and less than 600 nm. Although the maximum luminance PS may be less than 35 cd/m$^2$, the maximum luminance PS is more preferably greater than or equal to 35 cd/m$^2$. In this case, the integrated photometric luminance of the type $\beta$ unit 102 is greater than or equal to 35 cd/m$^2$. Although the maximum luminance PS may be less than 100 cd/m$^2$, the maximum luminance PS is still more preferably greater than or equal to 100 cd/m$^2$. In this case, the integrated photometric luminance of the type $\beta$ unit 102 is greater than or equal to 100 cd/m$^2$. Although the maximum luminance PS may be greater than or equal to 1000 cd/m$^2$, the maximum luminance PS may be less than 1000 cd/m$^2$. The integrated photometric luminance of the type β unit 102 may be less than 1000 cd/m$^2$. Although the maximum luminance PS may be greater than or equal to 500 cd/m$^2$, the maximum luminance PS may be less than 500 cd/m$^2$. The integrated photometric luminance of the type β unit 102 may be less than 500 cd/m$^2$. The maximum luminance PS may be a peak luminance exhibited by the type β unit 102. The maximum wavelength λS may be a peak wavelength of the type β unit 102.

Fig. 2B also illustrates a concept of the spectral characteristic S of the luminance of light exhibited by the type γ unit 103 (type γ element 113 and/or type β pixel 123). The type γ unit 103 (type γ element 113 and/or type γ pixel 123) also exhibits a maximum luminance of greater than or equal to 0.04 cd/m$^2$ in terms of spectral photometric luminance at a wavelength in a range of greater than or equal to 400 nm and less than 650 nm. Accordingly, the type γ unit 103 (type γ element 113 and/or type γ pixel 123) exhibits an integrated photometric luminance of greater than or equal to 0.04 cd/m$^2$. However, a wavelength at which the type y unit 103 exhibits the maximum luminance may differ from a wavelength at which the type β unit 102 exhibits the maximum luminance. The maximum luminance exhibited by the type γ unit 103 may also differ from the maximum luminance exhibited by the type β unit 102.

Fig. 2B also illustrates a concept of the spectral characteristic S of the luminance of light exhibited by the type δ unit 104 (type δ element 114 and/or type δ pixel 124). The type δ unit 104 (type δ element 114 and/or type δ pixel 124) also exhibits a maximum luminance of greater than or equal to 0.04 cd/m$^2$ in terms of spectral photometric luminance at a wavelength in a range of greater than or equal to 400 nm and less than 650 nm. Accordingly, the type δ unit 104 (type δ element 114 and/or type δ pixel 124) exhibits an integrated photometric luminance of greater than or equal to 0.04 cd/m$^2$. However, a wavelength at which the type δ unit 104 exhibits the maximum luminance may differ from a wavelength at which the type β unit 102 exhibits the maximum luminance. A wavelength at which the type δ unit 104 exhibits the maximum luminance may also differ from a wavelength at which the type γ unit 103 exhibits the maximum luminance.

The maximum luminance PS exhibited by the type γ unit 103 and the type δ unit 104 simply needs to be greater than or equal to 0.04 cd/m$^2$. In this case, the integrated photometric luminance of the type γ unit 103 and the type δ unit 104 is greater than or equal to 0.04 cd/m$^2$. When the maximum luminance PL is greater than or equal to 0.04 cd/m$^2$, the spectral radiance at the wavelength where the maximum luminance is reached is greater than or equal to 0.04/ (683*V (λL)) [W/sr/m$^2$/nm] . Although the maximum luminance exhibited by the type γ unit 103 and the type δ unit 104 may be less than 5 cd/m$^2$, it is preferable that the maximum luminance exhibited by the type γ unit 103 and the type δ unit 104 be greater than or equal to 5 cd/m$^2$. In this case, the integrated photometric luminance of the type γ unit 103 and the type δ unit 104 is greater than or equal to 5 cd/m$^2$. When the maximum luminance PS is greater than or equal to 5 cd/m$^2$, the spectral radiance at the wavelength where the maximum luminance is reached is greater than or equal to 5/ (683*V(λL)) [W/sr/m$^2$/nm] . Although the maximum luminance exhibited by the type γ unit 103 and the type δ unit 104 may be less than 35 cd/m$^2$, the maximum luminance exhibited by the type γ unit 103 and the type δ unit 104 is more preferably greater than or equal to 35 cd/m$^2$. In this case, the integrated photometric luminance of the type γ unit 103 and the type δ unit 104 is greater than or equal to 35 cd/m$^2$. Although the maximum luminance exhibited by the type γ unit 103 and the type δ unit 104 may be less than 100 cd/m$^2$, the maximum luminance exhibited by the type γ unit 103 and the type δ unit 104 is still more preferably greater than or equal to 100 cd/m$^2$. In this case, the integrated photometric luminance of the type γ unit 103 and the type δ unit 104 is greater than or equal to 100 cd/m$^2$. Although the maximum luminance exhibited by the type γ unit 103 and the type δ unit 104 may be greater than or equal to 1000 cd/m$^2$, the maximum luminance exhibited by the type γ unit 103 and the type δ unit 104 may be less than 1000 cd/m$^2$. The integrated photometric luminance of the type γ unit 103 and the type δ unit 104 may be less than 1000 cd/m$^2$. Although the maximum luminance exhibited by the type γ unit 103 and the type δ unit 104 may be greater than or equal to 500 cd/m$^2$, the maximum luminance exhibited by the type γ unit 103 and the type δ unit 104 may be less than 500 cd/m$^2$. The integrated photometric luminance of the type γ unit 103 and the type δ unit 104 may be less than 500 cd/m$^2$.

The maximum luminances PL and PS simply need to be exhibited at any display level (e.g., emission intensity) of the display unit 100 (element 110 or pixel 120). To determine the performance of the display device 1, however, it is preferable that the maximum luminances PL and PS be exhibited at the highest display level (e.g., highest emission intensity) of the display unit 100 (element 110 or pixel 120).

In a typical display device 1, where the element unit displays the image 15 in a plurality of colors, the elements 110 may substantially match the pixels 120. Therefore, the elements 110 can be referred to as the pixels 120. The maximum luminances PL and PS are luminances with which the display device 1 can perform display, and it is obvious that these luminances can be recognized by the human eye. Light that exists only inside the display device 1 and cannot be taken out of the display device 1 is not the display unit 100. Such light cannot be recognized by the eye of a person who looks at the display, and thus is not the subject of the maximum luminances PL and PS. For example, even when light that satisfies the spectral characteristic L is used as the light sources 11 and 12, the display device 1 may not exhibit a sufficient luminance at the wavelength λL if transmittance at the wavelength λL is limited, for example, by a color filter.

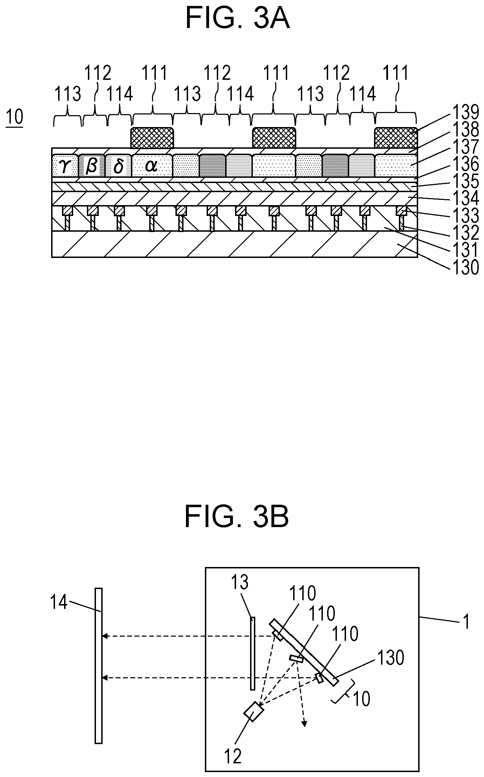

Fig. 3A is a cross-sectional view of the element unit 10. In the example of Fig. 3A, the elements 110 included in the element unit 10 each exhibit light of a different wavelength (color) depending on the type. A color exhibited by each of the plurality of elements 110 may be an emitted color emitted by the element 110, a transmitted color transmitted by the element 110, a reflected color reflected by the element 110. By observing the element unit 10 directly or indirectly through an optical system, such as a lens, the observer recognizes light exhibited by the plurality of elements 110 of the element unit 10 as the image 15, which is a collection of pixels 120. That is, the pixels 120 included in the image 15 each exhibit light (color) of a different wavelength depending on the type.

The display device 1 illustrated in Fig. 3A will now be described in detail. The element unit 10 may include a substrate 130 including a semiconductor element, such as a transistor, a wire 132 on the substrate 130, and an interlayer insulating film 131 around the wire 132. The element unit 10 may include an electrode 133 connected to the semiconductor element in the substrate 130 through the wire 132, a light emitting layer 134 on the electrode 133, and an electrode 135 on the light emitting layer 134. The element unit 10 may include a protective layer 136 on the electrode 135, a color filter array 137 on the protective layer 136, and a planarizing film 138 on the color filter array 137. Although the light emitting layer 134 of the present example emits white light, a light emitting layer that emits a different color for each element may be provided. The elements 111, 112, 113, and 114 include color filters of different transmitted colors in the color filter array 137. Of the plurality of elements 110, an element corresponding to the type $\alpha$ unit 101 may include a first color filter. Of the plurality of elements 110, an element corresponding to the type $\beta$ unit 102 may include a second color filter that differs in transmission characteristic from the first color filter. The plurality of elements 110 of the element unit 10 each have a different structure depending on the type. In the present example, however, the element 111 and the element 114 include the same color filter. The element 111 of the element unit 10 may include a wavelength adjuster 139. Light transmitted through the color filter common to the element 111 and the element 114 is adjusted by the wavelength adjuster 139 in such a way as to exhibit the maximum luminance PL greater than or equal to 0.04 cd/m$^2$ at the wavelength $\lambda$L in a range of greater than or equal to 650 nm and less than or equal to 700 nm.

In an example of the display device 1 of projection type, the element unit 10 and the image 15 are separated. The plurality of elements 110 of the element unit 10 have the same structure. In the example illustrated in Fig. 3B, the elements 110 included in the element unit 10 reflect or transmit light of the same wavelength (color) at the same time. That is, at some moments in time, a plurality of elements 110 may exhibit the same color. In other words, the plurality of elements 110 of the element unit 10 may be of a spatially single type.

In the display device 1 of reflective type, the wavelength of light displayed on a display surface may be controlled by temporally switching the wavelength of the light source 12 to control the wavelength of incident light on the element unit 10 that reflects light. In the display device 1 of reflective type, the wavelength of light displayed on the display surface may be controlled by temporally switching a wavelength selecting means 13 to control the wavelength of reflected light from the element unit 10 that reflects light. In the display device 1 of transmissive type, the wavelength of light displayed on the display surface may be controlled by temporally switching the wavelength of the light source 12 to control the wavelength of incident light on the element unit 10 that transmits light. In the display device 1 of transmissive type, the wavelength of light displayed on the display surface may be controlled by temporally switching the wavelength selecting means 13 to control the wavelength of light transmitted through the element unit 10 that transmits light. The wavelength selecting means 13 is temporally switched, for example, by rotating a color wheel. The element unit 10 includes the substrate 130 and the plurality of elements 110 disposed on the substrate 130. In the display device 1 illustrated in Fig. 3B, the elements 110 are, for example, reflective elements. When the light source 12 irradiates the element unit 10 with light, the direction of reflected light is controlled in accordance with an input signal received by the element unit 10. The reflected light is temporally assigned with colors by the wavelength selecting means 13 and displayed on a display surface 14 outside the display device 1. The display device 1 may be of scanning type.

Various color forming principles may be adopted for the display unit 100. For example, a color exhibited by the display unit 100 may be controlled by using a color filter. Alternatively, a color exhibited by the display unit 100 may be controlled by using a light emitting material exhibiting a specific emitted color. Also, various light emission principles may be adopted. Examples of adoptable light emission principles include electroluminescence (EL), photoluminescence (PL), and cathodoluminescence (CL). A plurality of light emission principles may be used in combination. Possible types of luminescence include fluorescence that occurs in allowed transition from an excited singlet state to a singlet ground state, and phosphorescence that occurs in forbidden transition from an excited triplet state to a singlet ground state. The light emitting material may be an organic material, an inorganic material, or an organic-inorganic hybrid material. For example, electroluminescence and photoluminescence may be used in combination. For example, a luminous body may be irradiated with primary light emitted by electroluminescence to produce secondary light from photoluminescence. In this case, the element 110 may include a portion that emits light by electroluminescence and a portion that emits light by photoluminescence. The wavelength adjuster 139, described above, may be a color filter or a luminous body that emits light by photoluminescence. For example, an organic material may be used for electroluminescence and an organic-inorganic hybrid material may be used for photoluminescence. The inorganic material may be a quantum dot material. Examples of the inorganic material that can exhibit a maximum luminance in a wavelength region of 650 nm to 750 nm include EuCeBaSrZnS, CeLnOS (Ln represents lanthanoid), MnKTiOF, EuCaAlSi, CaLnSbMnO, and BaLnSbMnO. The elemental ratios of these materials may be appropriately set in such a way that the peak wavelength in light emission is 650 nm to 750 nm. Examples of the inorganic material that can exhibit a maximum luminance in a wavelength region of 650 nm to 750 nm include those described in PCT Japanese Translation Patent Publication No. 2013-505009, Japanese Patent Laid-Open No. 2016-196611, Japanese Patent Laid-Open No. 2016-79213, and Japanese Patent Laid-Open No. 2013-1877. Examples of the organic material that can exhibit a maximum luminance in a wavelength region of 650 nm to 750 nm include tris (8-hydroxyquinolinato) aluminum (III) and polyimide material. The polyimide material may be a polyimide in which nitrogens (N) are bound via a divalent organic group including an alicyclic structure and carbons (C) are bound via a quadrivalent aromatic group, or may be any appropriate material described in Japanese Patent Laid-Open No. 2008-274165. The luminance of the display unit 100 may be controlled by controlling injection energy in the various types of luminescence described above. The element unit 10 using electroluminescence may include organic EL elements or light emitting diodes (LEDs) arranged therein. The luminance of the display unit 100 may be controlled by controlling the transmittance of a liquid crystal element or the reflectance of a mirror element. The element unit 10 of the display device 1 of reflective type may be constituted by a liquid crystal on silicon (LCOS) or a digital micromirror device (DMD). The light source 11 or the light source 12 may be a backlight for the display device 1 that includes a transmissive display element in the element unit 10. In the display device 1 that includes a reflective display element in the element unit 10, the light source 12 may emit light for irradiating the element unit 10.

The apparatus EQP including the display device 1 may be a mobile apparatus, such as a smartphone, a mobile PC, or a tablet. The mobile apparatus, which is mainly for personal use, can be customized in a preferable way in accordance with the individual's color vision. The apparatus EQP including the display device 1 may be a wearable apparatus. The wearable apparatus is a type of mobile apparatus. The display device 1 is applicable to wearable devices, such as smart glasses, head mounted displays (HMDs), goggle displays, and smart contact lenses.

The apparatus EQP including the display device 1 may include an image pickup device. This is preferable because when the display device 1 displays an image taken by the image pickup device in the apparatus EQP, the displayed image is one that allows the user of the apparatus EQP to easily distinguish colors. The apparatus EQP including an image pickup device may be a camera or a camera-equipped information apparatus.

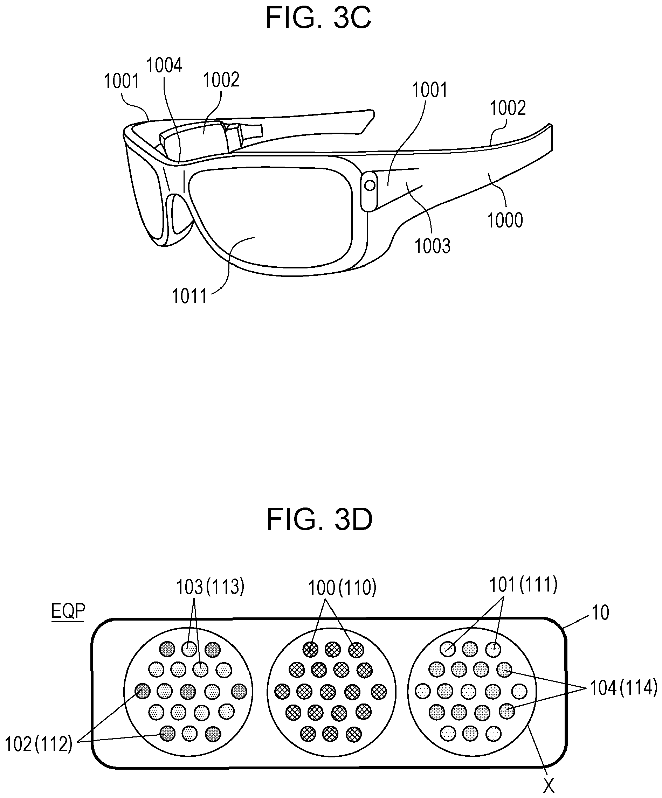

Fig. 3C is a schematic diagram for explaining a pair of smart glasses SG (wearable apparatus) as an example of the apparatus EQP. The pair of smart glasses SG is a spectacle apparatus and includes a frame 1000, which is a housing of a spectacle type. The frame 1000 includes temples 1003. The pair of smart glasses SG includes, for example, a display 1011, an image pickup unit 1001, a processor 1002, and a pupil detector 1004. The element unit 10 of the display device 1 may be adopted as the display 1011. The display 1011 is disposed at the position of each lens of the glasses in the present example, but may be disposed at any position depending on the display format. The processor 1002 may include the drive unit 60, the controller 40, and the power supply unit 70 of the display device 1. The image pickup unit 1001 may include an image pickup device, such as a CMOS image sensor, and a taking lens for forming an image on the image pickup device. The image pickup unit 1001 is disposed on the outer side of each temple 1003 of the glasses. The image pickup unit 1001 may be disposed in such a way as to overlap the display 1011. The processor 1002 is disposed on the inner side of each temple 1003 of the glasses. In any of the cases, an image is displayed on the display 1011. The pupil detector 1004 is disposed in a bridge of the frame 1000, but may be disposed in each temple 1003 or may be disposed at the position of each lens of the glasses. The processor 1002 may be configured to perform computing based on artificial intelligence. The power supply unit 70 may supply power not only to the display 1011, but also to the image pickup unit 1001, the processor 1002, the display 1011, and the pupil detector 1004. The smart glasses SG may include a communicating unit (not shown), through which other apparatuses can perform wired and/or wireless communication with the smart glasses SG. In the smart glasses SG, the processor 1002 may exchange information with external apparatuses through the communicating unit. The smart glasses SG may include two displays 1011, one for the left eye and the other for the right eye. The smart glasses SG may include two image pickup units 1001, one for the left eye and the other for the right eye. The timing of image pickup and display may be appropriately set for each of the image pickup units 1001 and the displays 1011 for the left eye and the right eye. Specifically, the timing may be set to pick up an image at the same time and display the image at different times, or to pick up an image at different times and display the image at the same time. Although the image pickup unit 1001 and the display 1011 may be disposed at different positions, the image pickup unit 1001 and the display 1011 may be disposed in such a way as to overlap in the line of sight.

The apparatus EQP including the display device 1 may be any one of an electronic board, a traffic light machine, and an in-vehicle indicator. When the display device 1 is used in public as in the case of an electronic board, a traffic light machine, or an in-vehicle indicator, it is necessary to ensure high visibility for both people with normal color vision and colorblind people. Although the apparatuses described above generally ensure visibility for people with normal color vision, they can also improve visibility for colorblind people by adopting the embodiments of the present invention.

An image displayed by an example of the display device 1 is typically a variable pattern, but it may be a fixed pattern. Fig. 3D illustrates the element unit 10 of a traffic light machine, which is an example of the apparatus EQP including the display device 1. The element unit 10 includes three fixed patterns, a red pattern X enclosed by a solid line X, a yellow pattern Y enclosed by a solid line, and a green (blue) pattern Z enclosed by a solid line. In accordance with the time, one of the red pattern X, the yellow pattern Y, and the green (blue) pattern Z illuminates. The red pattern X, the yellow pattern Y, and the green (blue) pattern Z are each constituted by a plurality of elements 110. The red pattern X may include a plurality of type α elements 111, and the red pattern X may include a plurality of type δ elements 114 in the present example. The green (blue) pattern Z may include a plurality of type β elements 112, and the green (blue) pattern Z may include a plurality of type γ elements 113 in the present example. The yellow pattern Y includes a plurality of elements 110 exhibiting a yellow color.

The effect of using the unit 101 having the spectral characteristic L and the unit 102 (and/or units 103 and 104) having the spectral characteristic S will now be described.

Light entering the human eye is received by photoreceptor cells on the retina. The photoreceptor cells are divided into two types, rods and cones, by their shape. Since the rods are capable of responding to weak light, the rods mainly function in dark places and the cones mainly function in bright places, depending on the intensity of light. The cones serve as a color sensor and are divided into three types, L cones, M cones, and S cones, which respond to different wavelength characteristics. In the majority of people, the L cones are said to have the highest absorbance at a wavelength of 560 ± 10 nm, the M cones are said to have the highest absorbance at a wavelength of 530 ± 10 nm, and the S cones are said to have the highest absorbance at a wavelength of 420 ± 10 nm.

Light emitted or reflected by a material causes responses of different magnitudes to occur in the three types of cones depending on the component. The differences in the amount of response create differences in color. For example, whether the color looks closer to red or green relates to a difference between the amount of response of the L cones and the amount of response of the M cones. The greater the difference, the closer the color looks to red, whereas the smaller the difference, the closer the color looks to green.

Vision in scenes with bright ambient light, where only the cones are responsive, is referred to as photopic vision. The photopic vision is vision in a region where the luminance is 1 cd/m$^2$ to 5 cd/m$^2$ or more, and colors can be distinguished in this luminance region. The boundary between photopic vision and mesopic vision varies among individuals and there are various theories on this boundary. Therefore, although the lower limit of luminance for photopic vision has been described as being 1 cd/m$^2$ to 5 cd/m$^2$, the photopic vision can be said to occur in a significant number of people if the luminance is simply greater than or equal to 5 cd/m$^2$.

Vision in scenes with dark ambient light, where only the rods are responsive, is referred to as scotopic vision. The scotopic vision is vision in a region where the luminance is 0.001 cd/m$^2$ to 0.034 cd/m$^2$ or below. In scotopic vision, the L cones are unresponsive and are thought not to allow colors to be distinguished.

Vision between photopic vision and scotopic vision is referred to as mesopic vision, where both the cones and the rods are responsive. Under ambient light of a mesopic level, where the rods gradually increase their sensitivity and the cones are still responsive, both color sensation and color perception are known to vary in a complex manner. The boundary between scotopic vision and mesopic vision also varies among individuals and there are various theories on this boundary. Therefore, although the upper limit of luminance for scotopic vision has been described as being 0.001 cd/m$^2$ to 0.034 cd/m$^2$ or below, the mesopic vision can be said to occur in a significant number of people if the luminance is simply greater than or equal to 0.04 cd/m$^2$.

As described above, the human photoreceptor cells include a plurality of cells called rods, as well as the L cones, the M cones, and the S cones. The ratio of these cells and the spectral absorption characteristic vary among individuals. Therefore, the color vision or color matching functions that humans have are diverse, and the diversity is particularly complex and significant in the mesopic region. Since color vision is diverse, colors used on printed materials or display devices are perceived differently from person to person.

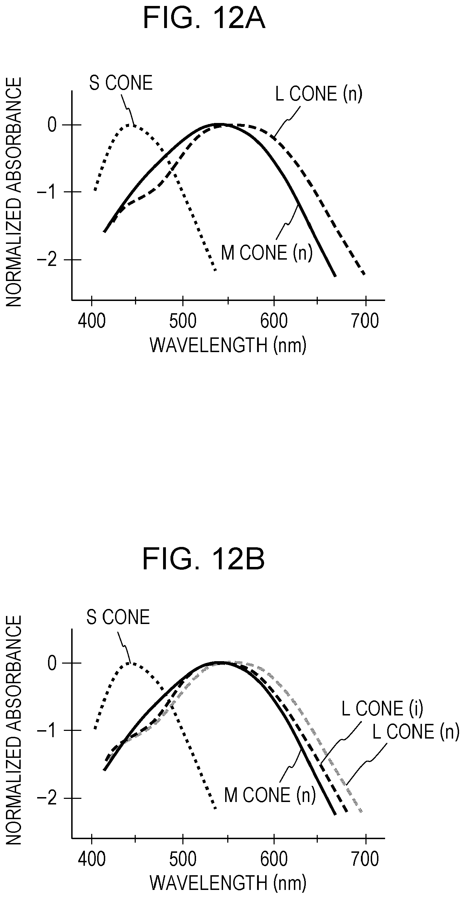

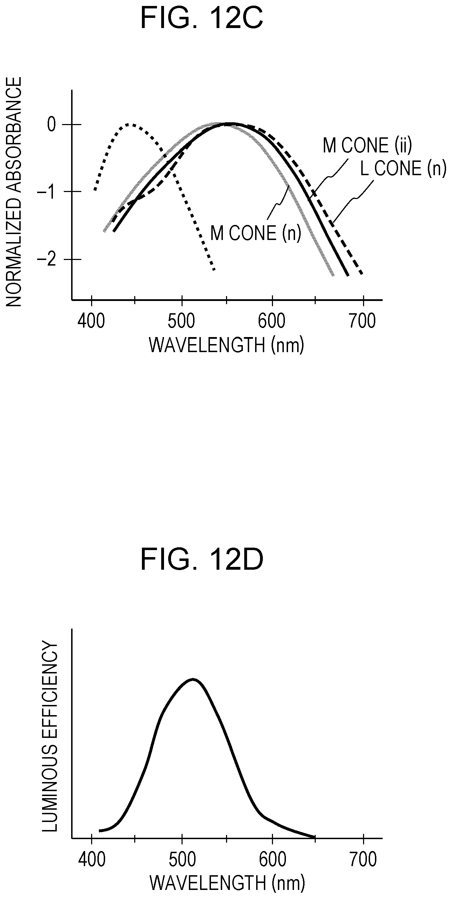

Color vision the majority of people have is referred to as normal color vision. Fig. 12A illustrates an example of wavelength sensitivity characteristics of cones in normal color vision. On the other hand, there are people with color vision different from normal color vision (generally referred to as colorblind people) because at least one of the three types of cones is defective or imperfect. About 3% of the world's population is said to be colorblind. Most of the colorblind people are said to have "monochromatism" where the L cones are dysfunctional, or "dichromatism" where the M cones are dysfunctional. Fig. 12B illustrates an example of wavelength sensitivity characteristics of cones in monochromatism, and Fig. 12C illustrates an example of wavelength sensitivity characteristics of cones in dichromatism. As illustrated in Fig. 12B, the wavelength sensitivity characteristic of the L cones in monochromatism (indicated by L cone (i)) differs from the wavelength sensitivity characteristic of the L cones in normal color vision (indicated by L cone (n)). As illustrated in Fig. 12B, the wavelength sensitivity characteristic of the M cones in dichromatism (indicated by M cone (ii)) differs from the wavelength sensitivity characteristic of the M cones in normal color vision (indicated by M cone (n)). In the case of monochromatism, as illustrated in Fig. 12B, the sensitivity region of the L cones is often shifted to shorter wavelengths. This increases an overlap between the spectral absorption characteristics of the L cones and the M cones and makes it difficult to perceive a color difference in the red to green wavelength region. In the case of dichromatism, as illustrated in Fig. 12C, the sensitivity region of the M cones is often shifted to longer wavelengths. As in the case of monochromatism, this increases an overlap between the spectral absorption characteristics of the L cones and the M cones and makes it difficult to perceive a color difference in the red to green wavelength region.

To correct differences in color perception among individuals, the display device may include red pixels with a peak wavelength of 630 nm, so that the red pixels can allow a dominant response of the L cones. In monochromatism and dichromatism, however, light of 630 nm cannot create a significant difference in the amount of response between the L cones and the M cones. Therefore, although this display device can make correction for persons with normal color vision, it is difficult to allow persons with monochromatism and dichromatism to distinguish colors more easily.

Fig. 12D illustrates an example of wavelength sensitivity characteristics of rods. The rods have a sensitivity in a wavelength region of greater than or equal to 400 nm and less than 650 nm, and a wavelength corresponding to the peak sensitivity (i.e., peak wavelength) is 500 ± 10 nm. In the mesopic vision described above, the color vision is said to be influenced by the response of the rods, and both color sensation and color perception are known to vary in a complex manner. Specifically, an increase in the response of the rods is known to produce perception of blue and green colors.

To allow persons with monochromatism and dichromatism to distinguish red color, the intensity of emission from red pixels may be made higher than that for persons with normal color vision. However, when the red pixels are illuminated with high intensity, the rods may be excessively excited if the emission wavelength of the red pixels is in a wavelength region of less than 650 nm. As a result, particularly in the mesopic region, this not only increases perception of red color but also produces perception of blue and green colors, and makes the correction extremely complex. Accordingly, a discussion will be given to provide a display device that allows a colorblind person to easily distinguish colors. Here, distinguishing a specific color means that a person perceives given light as a second color, not a first color.

As illustrated in Fig. 12B and Fig. 12C, even in the case of a colorblind person with monochromatism or dichromatism, the sensitivity of the L cones and the sensitivity of the M cones differ in a wavelength region of 600 nm to 700 nm. In a wavelength region of 650 nm to 700 nm, the difference between the sensitivity of the L cones and the sensitivity of the M cones is more significant. Accordingly, the present inventor thought that by performing display using light for stimulating the L cones in a wavelength region of 600 nm to 700 nm, or preferably in a wavelength region of 650 nm to 700 nm, it would become easier for a colorblind person with monochromatism or dichromatism to distinguish a red color. An effective way to suppress excessive excitement of the rods, as described above, is to stimulate the L cones outside a wavelength region of greater than or equal to 400 nm and less than 650 nm where the rods are responsive, that is, in a wavelength region of greater than or equal to 650 nm and less than or equal to 700 nm. Since the rods are less functional in the photopic vision region, the L cones may be stimulated in a wavelength region of greater than or equal to 600 nm and less than or equal to 700 nm, or the L cones may be stimulated in a wavelength region of greater than or equal to 600 nm and less than or equal to 650 nm.

In the present embodiment, the type α unit 101 exhibits a maximum luminance greater than or equal to 0.04 cd/m$^2$ (or integrated photometric luminance greater than or equal to 0.04 cd/m$^2$) at the wavelength λL in a range of greater than or equal to 650 nm and less than or equal to 700 nm, and allows mesopic vision or photopic vision. This makes it possible to distinguish colors by using a difference in sensitivity between the L cones and the M cones. That is, a colorblind person who sees the image 15 displayed on the display device 1 of the present embodiment can perceive light exhibited by the type α unit 101 as red. It is also possible to distinguish (discriminate) red from a color exhibited by the type β unit 102 (and/or the type γ unit 103 and the type δ unit 104) different from the type α unit 101. The display device can thus be provided which allows a colorblind person to easily distinguish colors.

Some embodiments, which are more specific examples of the first embodiment, will now be described. Table 1 shows a correspondence between the types α, β, γ, δ, and ε and spectral characteristics La, Lb, Lc, Ld, R, G, M, and B in second to sixth embodiments described below. Each value in parentheses indicates a peak wavelength in the corresponding unit. The spectral characteristics La, Lb, Lc, and Ld are categorized as narrower concepts of the spectral characteristic L described above, and have the features of the spectral characteristic L. The spectral characteristics R, G, M, and B are categorized as narrower concepts of the spectral characteristic S described above, and have the features of the spectral characteristic S. Combinations of the spectral characteristics are not limited to those in the embodiments described below. A unit having any of the spectral characteristics L, La, Lb, Lc, and Ld and a unit having any of the spectral characteristics R, G, M, and B may be used in combination to form the element unit 10 and the image 15.

[Table 1]

|        | Second Embodiment | Third Embodiment | Fourth Embodiment | Fifth Embodiment | Sixth Embodiment |
|--------|-------------------|------------------|-------------------|------------------|------------------|
| Type α | La (670 nm)       | Lb (680 nm)      | Lc (670 nm)       | Ld (680 nm)      | Ld (680 nm)      |
| Type β | Ga (530 nm)       | M (500 nm)       | Gb (530 nm)       | M (500 nm)       | Gb (530 nm)      |
| Type γ | B (420 nm)        | B (420 nm)       | B (420 nm)        | B (420 nm)       | B (420 nm)       |
| Type δ | -                 | -                | -                 | R (600 nm)       | R (600 nm)       |
| Type ε | -                 | -                | -                 | -                | M (500 nm)       |

<Second Embodiment>

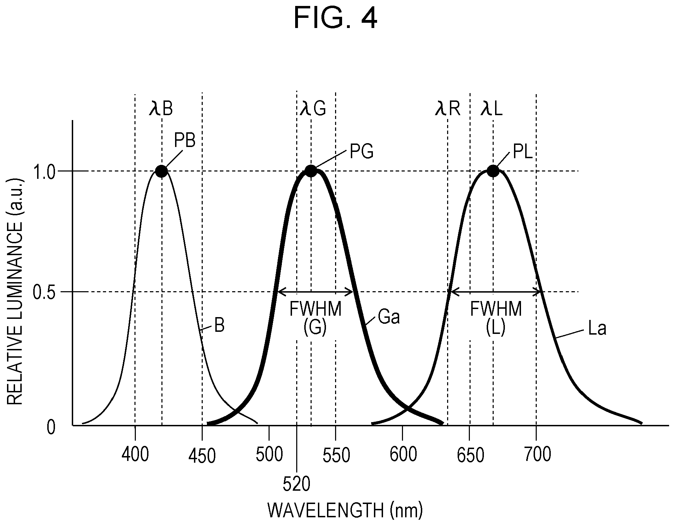

Fig. 4 illustrates an example of spectral characteristics of the display device 1 according to a second embodiment. In the second embodiment, the display unit 100 described in the first embodiment is of three types, the unit 101, the unit 102, and the unit 103. Fig. 4 illustrates the spectral characteristic La of the unit 101, the spectral characteristic Ga of the unit 102, and the spectral characteristic B of the unit 103. The spectral characteristics in Fig. 4 each are shown as a relative luminance normalized at the peak luminance of the display unit.

The unit 101 having the spectral characteristic La exhibits the maximum luminance PL greater than or equal to 0.04 cd/m² in terms of spectral photometric luminance at the wavelength λL in a range of greater than or equal to 650 nm and less than or equal to 700 nm. In the present example, the wavelength λL is the peak wavelength of the unit 101 and the peak wavelength (wavelength λL) of the unit 101 having the spectral characteristic La is 670 nm. The unit 102 having the spectral characteristic Ga exhibits the maximum luminance PG greater than or equal to 0.04 cd/m² at the wavelength λG in a range of greater than or equal to 520 nm and less than 550 nm. In the present example, the wavelength λG is the peak wavelength of the unit 102 and the peak wavelength (wavelength λG) of the unit 102 having the spectral characteristic Ga is 530 nm. The unit 103 having the spectral characteristic B exhibits the maximum luminance PG greater than or equal to 0.04 cd/m² at the wavelength λG in a range of greater than or equal to 400 nm and less than 480 nm. The wavelength λG at which the maximum luminance PG is exhibited is preferably in a range of greater than or equal to 400 nm and less than 450 nm. In the present example, the wavelength λB is the peak wavelength of the unit 103 and the peak wavelength (wavelength λB) of the unit 103 having the spectral characteristic B is 420 nm.

In the second embodiment, the unit 101 has the spectral characteristic La. This makes it possible to allow a dominant response of the L cones, for example, even for persons with the wavelength sensitivity characteristics illustrated in Fig. 12B and Fig. 12C. Colorblind persons can thus distinguish red color more easily.

The unit 101 is said to require the function of allowing the L cones to respond, and the cones respond to a luminance greater than or equal to 0.04 cd/m². Therefore, the maximum luminance PL of the unit 101 simply needs to be greater than or equal to 0.04 cd/m² in terms of spectral photometric luminance, and the luminance of the unit 101 simply needs to be greater than or equal to 0.04 cd/m² in terms of integrated photometric luminance. A luminance region of greater than or equal to 5 cd/m², which is a photopic vision region, facilitates color creation in the display device 1. Therefore, the maximum luminance PL of the unit 101 is preferably greater than or equal to 5 cd/m² in terms of spectral photometric luminance, and the luminance of the unit 101 is preferably greater than or equal to 5 cd/m² in terms of integrated photometric luminance. Ergonomically, the luminance of the display device is said to be preferably greater than or equal to 35 cd/m², and is said to be preferably 100 cd/m² under bright ambient light. Accordingly, it is also preferable that the maximum luminance PL of the unit 101 of the second embodiment be greater than or equal to 35 cd/m², and that the luminance of the unit 101 of the second embodiment be greater than or equal to 35 cd/m² in terms of integrated photometric luminance. The luminance of the unit 101 of the second embodiment is further preferably greater than or equal to 100 cd/m² in terms of integrated photometric luminance.

The wavelength λL at which the unit 101 of the second embodiment exhibits the maximum luminance PL is in a wavelength region where the sensitivity of the cones is lower than at the wavelengths λG and λB for the other units 102 and 103. Therefore, the maximum intensity PL of the unit 101 is preferably set higher than the maximum intensities PG and PB of the other units 102 and 103.

In the second embodiment, the luminance at a wavelength λR less than 650 nm in the spectral characteristic La is greater than or equal to half the maximum luminance PL. The luminance at 650 nm in the spectral characteristic La is also greater than or equal to half the maximum luminance PL. In the present example, a half width (spectrum half width) FWHM (L) for the maximum luminance PL in the spectral characteristic La is greater than or equal to 50 nm. The half width FWHM (L) in the present example is 70 nm. The spectrum half width for a given luminance is a wavelength width where, in a spectrum distribution of light output, the relative luminance is greater than or equal to 50% of the given luminance. By thus increasing the luminance at the wavelength λR less than 650 nm in the spectral characteristic La, it is possible to ensure luminance in a wavelength region of less than 650 nm in emission from the unit 101 and to stimulate the rods. It is thus possible to ensure sensitivity to light particularly in the mesopic region.

The maximum luminance of the unit 101 in a wavelength region of less than 650 nm is preferably lower than the maximum luminance PL of the unit 101 in a wavelength region of greater than or equal to 650 nm and less than or equal to 700 nm. In this case, even when the unit 101 is made brighter, the rods are not excessively stimulated and the perception of blue and green colors is not excessively increased. This facilitates hue correction in the mesopic vision. The wavelength region of greater than or equal to 650 nm and less than or equal to 700 nm is a region where the L cones are less sensitive. Therefore, the maximum luminance PL of the unit 101 is preferably set higher than the maximum luminance PG of the unit 102 and the maximum luminance PB of the unit 103.

The luminance at 520 nm in the spectral characteristic Ga is greater than or equal to half the maximum luminance PG. A half width FWHM (G) for the maximum luminance PG in the spectral characteristic Ga is greater than or equal to 50 nm. The half width (spectrum half width) FWHM (G) in the present example is 60 nm. By thus increasing the luminance at a wavelength of 480 nm to 520 nm in the spectral characteristic Ga, it is possible to ensure luminance in a wavelength region of 480 nm to 520 nm in emission from the unit 102. The M cones can thus be stimulated, and this facilitates color distinction between red and green particularly in a region close to green.

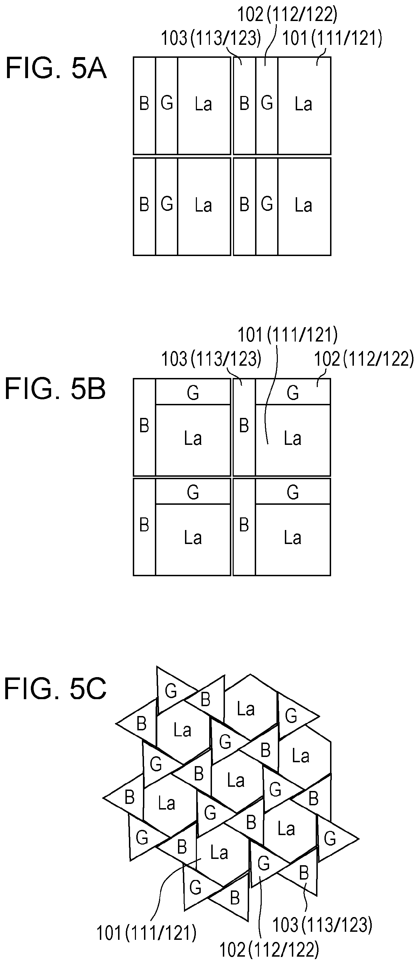

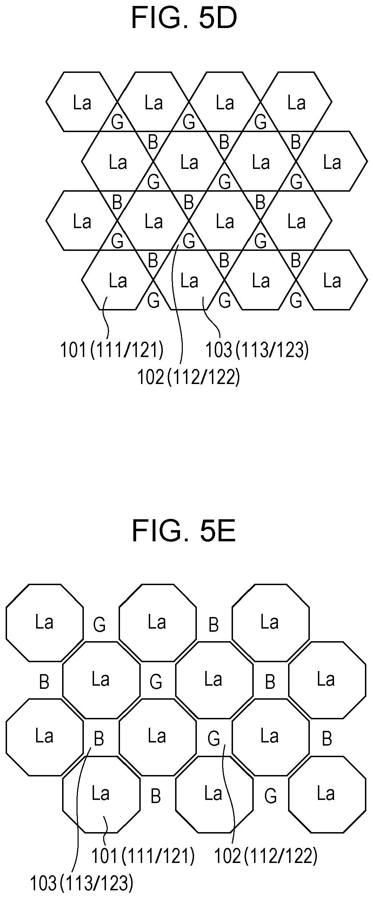

A pixel arrangement of the element unit 10 according to the present embodiment is not particularly limited. For example, the pixel arrangement may be a stripe arrangement illustrated in Fig. 5A, an S-stripe arrangement illustrated in Fig. 5B, a honeycomb structure illustrated in Fig. 5C, or a PenTile structure. As illustrated in Fig. 5A to Fig. 5E, it is preferable that the unit 101 having the spectral characteristic La be larger than the other units 102 and 103. When the unit 101 is larger, it is possible to improve the intensity of light in a wavelength region of greater than or equal to 650 nm, and provide the amount of light necessary to allow the L cones to respond.

A peak wavelength of 670 nm and a half width of 70 nm for the unit 101 of the present embodiment may be achieved by appropriately producing a color filter using a color resist or a quantum dot material, or may be achieved by appropriately selecting a light emitting material, such as an organic material or an inorganic material.

<Third Embodiment>

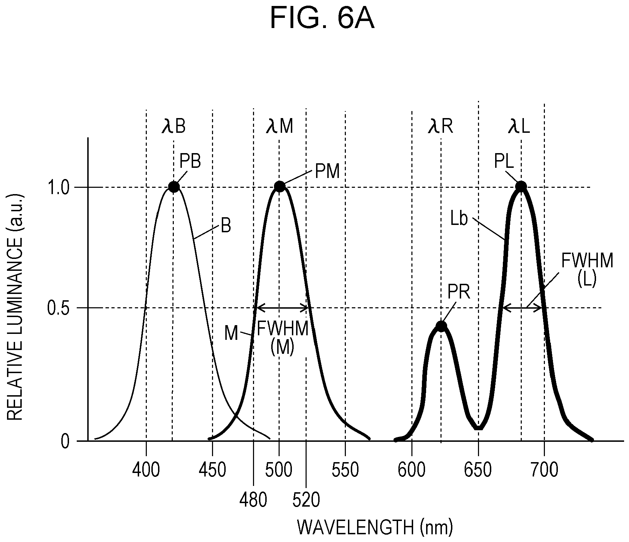

Fig. 6A illustrates an example of spectral characteristics of the display device 1 according to a third embodiment. In the third embodiment, the display unit 100 described in the first embodiment is of three types, the unit 101, the unit 102, and the unit 103. Fig. 6A illustrates the spectral characteristic Lb of the unit 101, the spectral characteristic M of the unit 102, and the spectral characteristic B of the unit 103. The spectral characteristics in Fig. 6A each are normalized at the peak luminance of the display unit. The spectral characteristic B will not be explained here, as it is the same as that in the second embodiment.

The unit 101 having the spectral characteristic Lb exhibits the maximum luminance PL greater than or equal to 0.04 cd/m$^2$ at the wavelength $\lambda$L in a range of greater than or equal to 650 nm and less than or equal to 700 nm. The unit 101 having the spectral characteristic Lb exhibits a maximum luminance PR greater than or equal to 0.04 cd/m$^2$ at the wavelength $\lambda$R in a range of greater than or equal to 550 nm and less than 650 nm. Accordingly, the unit 101 exhibits a luminance of greater than or equal to 0.08 cd/m$^2$ in terms of integrated photometric luminance. The maximum luminance PR in terms of spectral radiance is lower than the maximum luminance PL in terms of spectral radiance. In the present example, the maximum luminance PR in terms of spectral radiance is less than half the maximum luminance PL in terms of spectral radiance. However, the maximum luminance PR in terms of spectral radiance may be greater than or equal to half the maximum luminance PL in terms of spectral radiance. In the present example, the wavelength $\lambda$L is the peak wavelength of the unit 101, and the peak wavelength (wavelength $\lambda$L) of the unit 101 having the spectral characteristic Lb is 680 nm. In the present example, the wavelength $\lambda$R is 620 nm.

The unit 101 is said to require the function of allowing the L cones to respond, and the cones respond to a luminance of greater than or equal to 0.04 cd/m$^2$. Therefore, the maximum luminance PL exhibited by the unit 101 simply needs to be greater than or equal to 0.04 cd/m$^2$ in terms of spectral photometric luminance, and the luminance exhibited by the unit 101 simply needs to be greater than or equal to 0.04 cd/m$^2$ in terms of integrated photometric luminance. A region with a luminance of greater than or equal to 5 cd/m$^2$, which is a photopic vision region, facilitates color creation in the display device 1. Therefore, the maximum luminance PL exhibited by the unit 101 is preferably greater than or equal to 5 cd/m$^2$ in terms of spectral photometric luminance, and the luminance exhibited by the unit 101 is preferably greater than or equal to 5 cd/m$^2$ in terms of integrated photometric luminance. Ergonomically, the luminance of the display device is said to be preferably greater than or equal to 35 cd/m$^2$, and is said to be preferably 100 cd/m$^2$ under bright ambient light. Accordingly, the integrated luminance PL exhibited by the unit 101 of the third embodiment is also more preferably greater than or equal to 35 cd/m$^2$ in terms of spectral photometric luminance, and the luminance exhibited by the unit 101 of the third embodiment is also more preferably greater than or equal to 35 cd/m$^2$ in terms of spectral photometric luminance. The luminance of the unit 101 according to the third embodiment is still more preferably greater than or equal to 100 cd/m$^2$ in terms of integrated photometric luminance.

The unit 102 having the spectral characteristic M exhibits the maximum luminance PM greater than or equal to 0.04 cd/m$^2$ in terms of spectral photometric luminance at the wavelength $\lambda$M in a range of greater than or equal to 480 nm and less than 520 nm. Accordingly, the unit 102 exhibits a luminance of greater than or equal to 0.04 cd/m$^2$ in terms of integrated photometric luminance. In the present example, the wavelength $\lambda$M is the peak wavelength of the unit 102, and the peak wavelength (wavelength $\lambda$M) of the unit 102 having the spectral characteristic M is 500 nm. In the third embodiment, the unit 101 has the spectral characteristic Lb. This makes it possible to allow a dominant response of the L cones, for example, even for persons with the wavelength sensitivity characteristics illustrated in Fig. 12B and Fig. 12C. Colorblind persons can thus distinguish red color more easily. Similarly, when the maximum luminance exhibited by the unit 103 is greater than or equal to 0.04 cd/m$^2$ in terms of spectral photometric luminance, the luminance exhibited by the unit 103 is also greater than or equal to 0.04 cd/m$^2$ in terms of integrated photometric luminance. It is preferable that the maximum luminance exhibited by the unit 103 be also greater than or equal to 5 cd/m$^2$ in terms of spectral photometric luminance, because the luminance exhibited by the unit 103 is also greater than or equal to 5 cd/m$^2$ in terms

of integrated photometric luminance in this case.

In the third embodiment, the unit 101 exhibits the maximum luminance PR greater than or equal to 0.04 cd/m$^2$ in terms of spectral photometric luminance at the wavelength λR in a range of greater than or equal to 550 nm and less than 650 nm. This makes it possible to stimulate the rods in a wavelength region of greater than or equal to 550 nm and less than 650 nm. It is thus possible to ensure sensitivity to light particularly in the mesopic region. The peak luminance PL of the unit 101 may be higher than those of the other units 102 and 103. The maximum luminance PR at the wavelength λR greater than or equal to 550 nm and less than 650 nm is lower than the maximum luminance PL in a wavelength region of greater than or equal to 650 nm. The maximum luminance PR at the wavelength λR less than 650 nm is less than half the maximum luminance PL in a wavelength region of greater than or equal to 650 nm. A luminance at a wavelength of 650 nm may be lower than that at the wavelength λR less than 650 nm. In this case, even when the unit 101 emits light with a higher intensity, the rods are not excessively stimulated and this facilitates hue correction in the mesopic vision. Accordingly, it is preferable that the half width FWHM (L) for the maximum luminance PL in the spectral characteristic Lb be less than 50 nm. The half width FWHM (L) in the present example is 30 nm.

Also, in the third embodiment, the unit 102 exhibits the maximum luminance PM of greater than or equal to 0.04 cd/m$^2$ at the wavelength λM in a range of greater than or equal to 480 nm and less than 520 nm. It can be seen from Fig. 12A, Fig. 12B, and Fig. 12C that in a wavelength region of greater than or equal to 480 nm and less than 520 nm, unlike other wavelength regions, the response of the M cones tends to be dominant over the response of the L cones. That is, when the wavelength λM at which the unit 102 exhibits the maximum luminance PM is set to be greater than or equal to 480 nm and less than 520 nm, it is possible to facilitate color distinction between red and green particularly in a region close to green. The half width FWHM (M) for the maximum luminance PM in the spectral characteristic M is less than 50 nm. The half width FWHM (G) in the present example is 40 nm. Thus, the rods are not excessively stimulated and this facilitates hue correction in the mesopic vision.

In the third embodiment, as described above, the unit 101 having the spectral characteristic Lb can allow a dominant response of the L cones over the response of the M cones, even for persons with monochromatism or dichromatism. Similarly, the unit 102 having the spectral characteristic M can allow a dominant response of the M cones over the response of the L cones. This further facilitates color distinction between green and red.

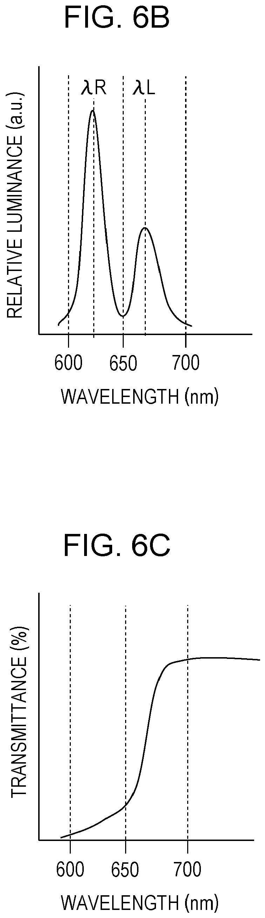

With reference to Fig. 6B and Fig. 6C, an example of the structure of the type δ unit 104 having a sub-peak in a wavelength region of less than 650 nm according to the present embodiment will be described. Fig. 6B illustrates an example of an emission spectrum of the light emitting layer 134 (see Fig. 3A) in a wavelength band of 600 nm to 700 nm. As illustrated in Fig. 6B, the maximum luminance of the light emitting layer 134 at the wavelength λL greater than or equal to 650 nm and less than or equal to 700 nm is weaker in emission intensity than the maximum luminance of the light emitting layer 134 at the wavelength λR greater than or equal to 600 nm and less than 650 nm. Therefore, the emission spectrum can be adjusted by the color filter array 137 and/or the wavelength adjuster 139 illustrated in Fig. 3A. For example, the color filters of the color filter array 137 in the elements 111 and 114 have a characteristic of transmitting red color. Although the type α and the type δ of the red color filters in the elements 111 and 114 are the same in the present example, they may be different. Fig. 6C illustrates a wavelength-transmittance characteristic of the wavelength adjuster 139, which is a color filter. The wavelength adjuster 139 has a wavelength-transmittance characteristic different from that of the type α and type δ color filters of the color filter array 137. The wavelength adjuster 139 has a relatively low transmittance in a wavelength region of 600 nm to 650 nm, and has a relatively high transmittance in a wavelength region of greater than or equal to 650 nm. Therefore, by superimposing the characteristic of the wavelength adjuster 139 on the spectral characteristic illustrated in Fig. 6B, the transmittance at the wavelength λR can be significantly reduced. As a result, the spectral characteristic Lb, where PR < PL, illustrated in Fig. 6A can be achieved. Although an example of using the wavelength adjuster 139 has been described here, the color filter illustrated in Fig. 6C may be used as the type α color filter for the element 111. The spectral characteristic Lb can thus be achieved by adjusting the emission spectrum and the transmittance of the color filter as described above.

The maximum luminance PM at the wavelength λM in a range of greater than or equal to 480 nm and less than 520 nm in the spectral characteristic M of the present embodiment can also be achieved by appropriately producing a color filter using a color resist or a quantum dot material, or may be achieved by appropriately selecting a light emitting material, such as an organic material or an inorganic material.

<Fourth Embodiment>

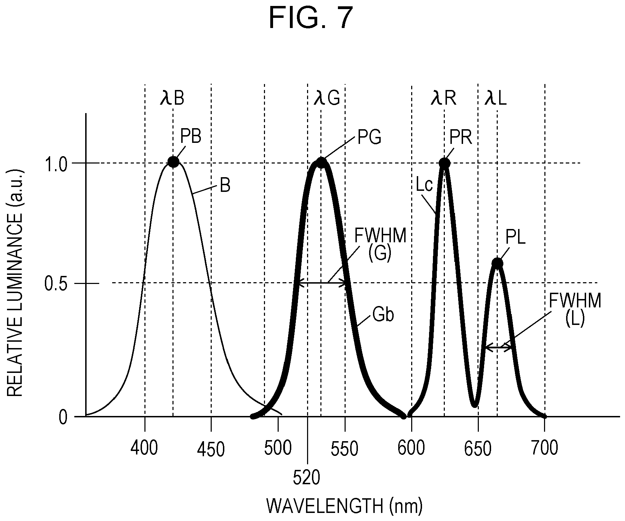

Fig. 7 illustrates an example of spectral characteristics of the display device 1 according to a fourth embodiment. In the fourth embodiment, the display unit 100 described in the first embodiment is of three types, the unit 101, the unit 102, and the unit 103. Fig. 7 illustrates the spectral characteristic Lc of the unit 101, a spectral characteristic Gb of the unit 102, and the spectral characteristic B of the unit 103. The spectral characteristics in Fig. 6 each are shown as a relative luminance normalized at the peak luminance of the display unit. The spectral characteristic B will not be explained here, as it is the same as that in the second embodiment.

The unit 101 having the spectral characteristic Lc exhibits the maximum luminance PL greater than or equal to 0.04 cd/m$^2$ at the wavelength λL in a range of greater than or equal to 650 nm and less than or equal to 700 nm. The unit 101 having the spectral characteristic Lc exhibits the maximum luminance PR greater than or equal to 0.04 cd/m$^2$ at the wavelength λR in a range of greater than or equal to 550 nm and less than 650 nm. The maximum luminance PR is higher than the maximum luminance PL. Although the maximum luminance PL is greater than or equal to half the maximum luminance PR in the present example, the maximum luminance PL may be less than half the maximum luminance PR. In the present example, the wavelength λR is the peak wavelength of the unit 101, and the peak wavelength (wavelength λR) of the unit 101 having the spectral characteristic Lc is 620 nm. In the present example, the wavelength λL is 670 nm.

In the fourth embodiment, the unit 101 has the spectral characteristic Lc. This makes it possible to allow a dominant response of the L cones, for example, even for persons with the wavelength sensitivity characteristics illustrated in Fig. 12B and Fig. 12C. Colorblind persons can thus distinguish red color more easily.

The half width FWHM (L) for the maximum luminance PL in the spectral characteristic Lc is less than 50 nm, and the half width FWHM (L) in the present example is 20 nm. Also, the half width FWHM (G) for the maximum luminance PG in the spectral characteristic Gb is less than 50 nm, and the half width FWHM (G) in the present example is 35 nm. By thus reducing the half width FWFH (L) and the half width FWFH (G), it is possible to suppress excessive stimulation of the M cones and make it easier to distinguish between red and green.

In the fourth embodiment, the unit 101 exhibits the maximum luminance PR greater than or equal to 0.04 cd/m$^2$ at the wavelength λR in a range of greater than or equal to 550 nm and less than 650 nm. This makes it possible to stimulate the rods in a wavelength region of greater than or equal to 550 nm and less than 650 nm. It is thus possible to ensure sensitivity to light particularly in the mesopic region. The maximum luminance PL of the unit 101 may be higher than those of the other units 102 and 103. The maximum luminance PR in a wavelength region of less than 650 nm is higher than the maximum luminance PL in a wavelength region of greater than or equal to 650 nm. In this case, when the unit 101 emits light with a higher intensity, the rods may be excessively stimulated in the mesopic region, but it is easy to perform hue correction in the photopic vision region. Accordingly, it is preferable that the maximum luminance PR be greater than or equal to 5 cd/m$^2$, which is the photopic vision region. When the maximum luminance PL is greater than or equal to half the maximum luminance PR, the L cones can be sufficiently stimulated by the unit 101.

To achieve the spectral characteristic Lc, the wavelength adjuster 139 having a relatively high transmittance in a wavelength range of 600 nm to 650 nm and a relatively low transmittance in a wavelength range of 650 nm to 700 nm may be used for the light emitting layer 134 having the spectral characteristic illustrated in Fig. 6B.

<Fifth Embodiment>

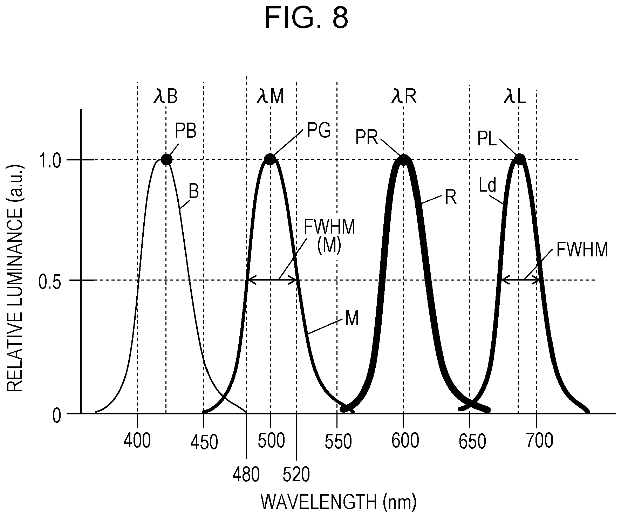

Fig. 8 illustrates an example of spectral characteristics of the display device 1 according to a fifth embodiment. In the fifth embodiment, the display unit 100 described in the first embodiment is of four types, the unit 101, the unit 102, the unit 103, and the unit 104. Fig. 8 illustrates the spectral characteristic Ld of the unit 101, the spectral characteristic M of the unit 102, the spectral characteristic B of the unit 103, and the spectral characteristic R of the unit 104. The spectral characteristics in Fig. 8 each are shown as a relative luminance normalized at the peak luminance of the display unit. The spectral characteristic B will not be explained here, as it is the same as that in the second to fourth embodiments.

The unit 104 having the spectral characteristic R exhibits the maximum luminance PR greater than or equal to 0.04 cd/m$^2$ in terms of spectral photometric luminance at the wavelength λR in a range of greater than or equal to 550 nm and less than 650 nm. Therefore, the unit 104 exhibits an integrated photometric luminance of greater than or equal to 0.04 cd/m$^2$. In the present example, in the present example, the wavelength λR is the peak wavelength of the unit 104 and the peak wavelength (wavelength λR) of the unit 104 having the spectral characteristic R is 600 nm.

The unit 101 having the spectral characteristic Ld exhibits the maximum luminance PL greater than or equal to 0.04 cd/m$^2$ in terms of spectral photometric luminance at the wavelength λL in a range of greater than or equal to 650 nm and less than or equal to 700 nm. Therefore, the unit 101 exhibits an integrated photometric luminance of greater than or equal to 0.04 cd/m$^2$. In the present example, the wavelength λL is the peak wavelength of the unit 101, and the peak wavelength (wavelength λL) of the unit 101 having the spectral characteristic Ld is 670 nm. Thus, even for persons with the wavelength sensitivity characteristics illustrated in Fig. 12B and Fig. 12C, it is possible to allow a dominant response of the L cones and this makes it easier to distinguish red color.

In the fifth embodiment, a spectral radiance at a wavelength of greater than or equal to 550 nm and less than 650 nm in the spectral characteristic Ld is less than half the maximum luminance PL in terms of spectral radiance. A spectral radiance at 650 nm in the spectral characteristic Ld is also less than half the maximum luminance PL in terms of the spectral radiance. In the present example, the half width (spectrum half width) FWHM (L) for the maximum luminance PL in the spectral characteristic Ld is less than 50 nm. In the fifth embodiment, the display unit 100 includes both the unit 101 having the spectral characteristic Ld and the unit 104 having the spectral characteristic R. The wavelength λR at which the unit 104 exhibits the maximum luminance PR is set in a wavelength region where the sensitivity of the L cones is sufficiently high and the rods are also sensitive. That is, in the fifth embodiment, the unit 104 having the spectral characteristic R has the function of not only stimulating the response of the L cones in an energy efficient manner, but also allowing the rods to respond. Accordingly, the unit 101 having the spectral characteristic Ld simply needs to have the function of allowing a dominant response of the L cones over the response of the M cones. The half width FWHM (L) for the unit 101 is less than 50 nm, so that the unit 101 stimulates the L cones while minimizing the stimulation of the M cones in a wavelength region where there is a difference in response between the L cones and the M cones. This makes it easier to distinguish colors.

The wavelength $\lambda L$ at which the unit 101 having the spectral characteristic Ld of the fifth embodiment exhibits the maximum luminance PL is in a wavelength region where the sensitivity of the L cones is lower than that at the wavelengths $\lambda M$ and $\lambda B$ where the other units 102 and 103 exhibit the maximum luminances PM and PB. Therefore, the maximum intensity PL of the unit 101 is preferably set higher than the maximum luminances PM and PB of the other units 102 and 103.

Light with the maximum luminance PR exhibited by the unit 101 having the spectral characteristic Ld of the fifth embodiment cannot be detected by the rods which have no sensitivity in a wavelength region of greater than or equal to 650 nm. That is, even when the luminance of the unit 101 having the spectral characteristic Ld is increased, for example, in the mesopic region, the excessive response of the rods and the perception of blue and green colors associated therewith are less likely to occur. It is thus possible to appropriately enhance the perception of red color and facilitate correction of color vision.

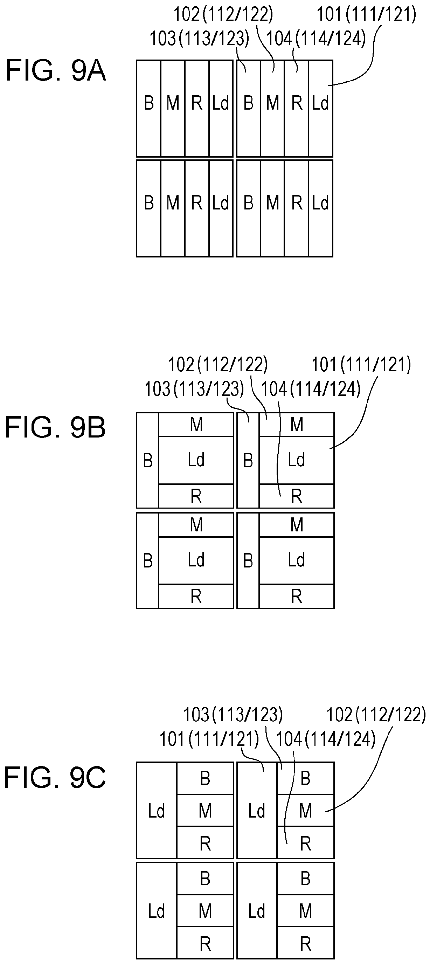

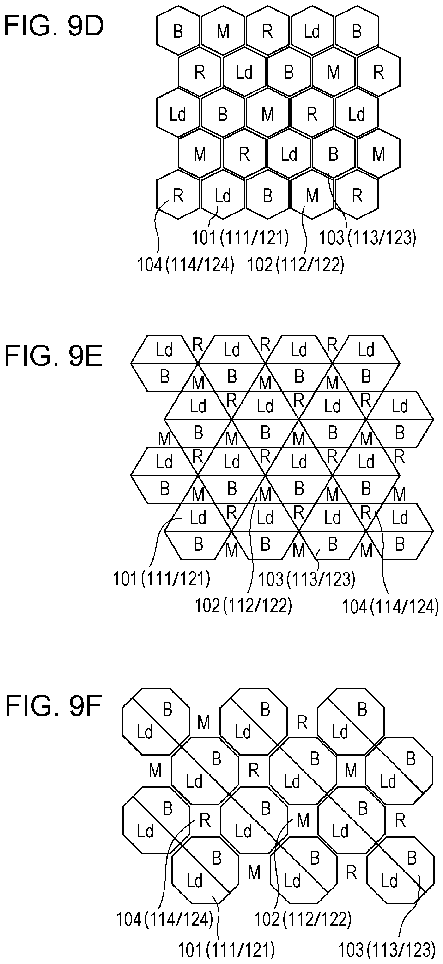

Examples of arrangement patterns of the display unit 100 according to the fifth embodiment are illustrated in Fig. 9A to Fig. 9F. The four types of the display unit 100 include the units 101, 102, 103, and 104. In the present embodiment, the arrangement of the display unit 100 may be stripe arrangement, such as that illustrated in Fig. 9A, or may be S-stripe arrangement, such as those illustrated in Fig. 9B and Fig. 9C. The arrangement of the display unit 100 may be delta arrangement, such as those illustrated in Fig. 9D to Fig. 9F, or may be PenTile arrangement (not shown). It is preferable, as illustrated in Fig. 9A to Fig. 9F, that the unit 101 having the spectral characteristic Ld be adjacent to the unit 104 having the spectral characteristic R. To increase the maximum luminance PL of the unit 101 having the spectral characteristic Ld, it is preferable that the area of the unit 101 be relatively large. For example, in Fig. 9B, Fig. 9C, Fig. 9E, and Fig. 9F, the area of the unit 101 having the spectral characteristic Ld is greater than the area of the unit 104 having the spectral characteristic R.

In the fifth embodiment, the unit 101 and the unit 104, which are independently controlled, allow an efficient response of the L cones. Also, a difference in sensitivity between the L cones and the M cones can be set to any level without considering the response of the rods. This improves flexibility in color correction and energy efficiency in image formation.

<Sixth Embodiment>

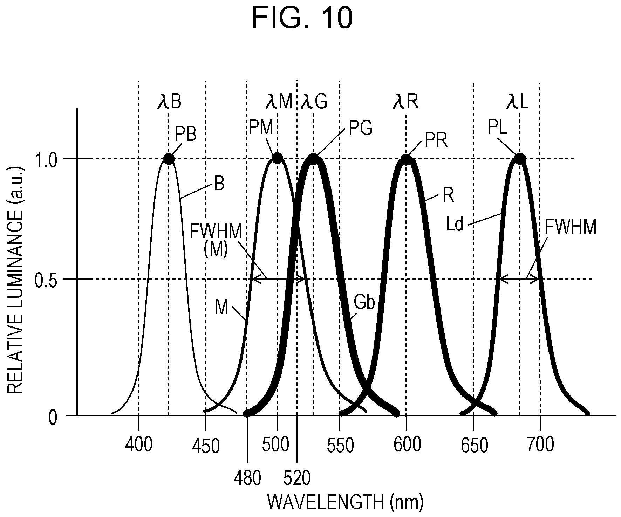

Fig. 10 illustrates an example of spectral characteristics of the display device 1 according to a sixth embodiment. In the sixth embodiment, the display unit 100 described in the first embodiment is of five types, which include the unit 105 as well as the aforementioned four types, the unit 101, the unit 102, the unit 103, and the unit 104. Fig. 10 illustrates the spectral characteristic Ld of the unit 101, the spectral characteristic Gb of the unit 102, the spectral characteristic B of the unit 103, the spectral characteristic R of the unit 104, and the spectral characteristic M of the unit 105. The spectral characteristics in Fig. 10 each are shown as a relative luminance normalized at the peak luminance of the display unit. The spectral characteristics Ld, R, and B will not be explained here, as they are the same as those in the fifth embodiment. The spectral characteristic M will not be explained here, as it is the same as that in the third embodiment and the fifth embodiment.

The peak wavelength of the unit 102 having the spectral characteristic Gb is the wavelength $\lambda G$ in a range of greater than or equal to 500 nm, which is the peak wavelength of the unit 105 having the spectral characteristic M, and less than 600 nm, which is the peak wavelength of the unit 104 having the spectral characteristic R. In the other embodiments, the peak wavelength of the unit 102 having the spectral characteristic Gb may also be greater than or equal to 500 nm and less than 600 nm. The unit 102 having the spectral characteristic Gb exhibits the maximum luminance PG greater than or equal to 0.04 cd/m$^2$ in terms of spectral photometric luminance at the wavelength $\lambda G$ in a range of greater than or equal to 520 nm and less than 550 nm. Therefore, the unit 102 exhibits an integrated photometric luminance of greater than or equal to 0.04 cd/m$^2$. In the present example, in the present example, the wavelength $\lambda G$ is the peak wavelength of the unit 102 and the peak wavelength (wavelength $\lambda G$) of the unit 102 having the spectral characteristic Gb is 530 nm.

The unit 105 having the spectral characteristic M exhibits the maximum luminance PM greater than or equal to 0.04 cd/m$^2$ in terms of spectral photometric luminance at the wavelength $\lambda M$ in a range of greater than or equal to 480 nm and less than 520 nm. Therefore, the unit 102 exhibits an integrated photometric luminance of greater than or equal to 0.04 cd/m$^2$. In the present example, in the present example, the wavelength $\lambda M$ is the peak wavelength of the unit 105 and the peak wavelength (wavelength $\lambda$M) of the unit 105 having the spectral characteristic M is 500 nm.

The unit 105 having the spectral characteristic M is said to require the function of allowing the M cones to respond, and the unit 105 having the spectral characteristic M can allow the M cones to respond dominantly. As illustrated in Fig. 12, the S cones respond dominantly at a wavelength of less than 480 nm, whereas the sensitivity of the L cones increases at a wavelength of greater than or equal to 520 nm. Accordingly, in the sixth embodiment, the wavelength $\lambda$M at which the spectral characteristic M exhibits the maximum luminance PM is set in a wavelength region of 480 nm to 520 nm. The half width FWHM (M) for the maximum luminance PM in the spectral characteristic M is set to be less than 50 nm.

As described above, the display device 1 according to the sixth embodiment includes both the unit 102 having the spectral characteristic Gb and the unit 105 having the spectral characteristic M. The wavelength $\lambda$G at which the unit 102 exhibits the maximum luminance PG is set in a wavelength region where the sensitivity of the M cones is sufficiently high. That is, in the sixth embodiment, the unit 102 having the spectral characteristic Gb simply needs to have the function of stimulating the response of the M cones in an energy efficient manner, and the unit 105 having the spectral characteristic M simply needs to have the function of making the amount of response of the M cones greater than the amount of response of the L cones.

The unit 105 is said to require the function of allowing the M cones to respond, and the M cones respond to a luminance of greater than or equal to 0.04 cd/m$^2$. Therefore, the maximum luminance PM of the unit 105 at the wavelength $\lambda$M simply needs to be greater than or equal to 0.04 cd/m$^2$ in terms of spectral photometric luminance, and the luminance of the unit 105 simply needs to be greater than or equal to 0.04 cd/m$^2$ in terms of integrated photometric luminance. A luminance region of greater than or equal to 5 cd/m$^2$, which is a photopic vision region, facilitates color creation in the display device 1. Therefore, the maximum luminance PM of the unit 105 is preferably greater than or equal to 5 cd/m$^2$ in terms of spectral photometric luminance, and the luminance of the unit 105 is preferably greater than or equal to 5 cd/m$^2$ in terms of integrated photometric luminance. Ergonomically, the luminance of the display device is said to be preferably greater than or equal to 35 cd/m$^2$, and is said to be preferably 100 cd/m$^2$ under bright ambient light. Accordingly, the maximum luminance PM of the unit 105 according to the sixth embodiment is also more preferably greater than or equal to 35 cd/m$^2$ in terms of spectral photometric luminance, and the luminance of the unit 105 according to the sixth embodiment is preferably greater than or equal to 35 cd/m$^2$ in terms of integrated photometric luminance. The luminance of the unit 105 according to the sixth embodiment is still more preferably greater than or equal to 100 cd/m$^2$ in terms of integrated photometric luminance.

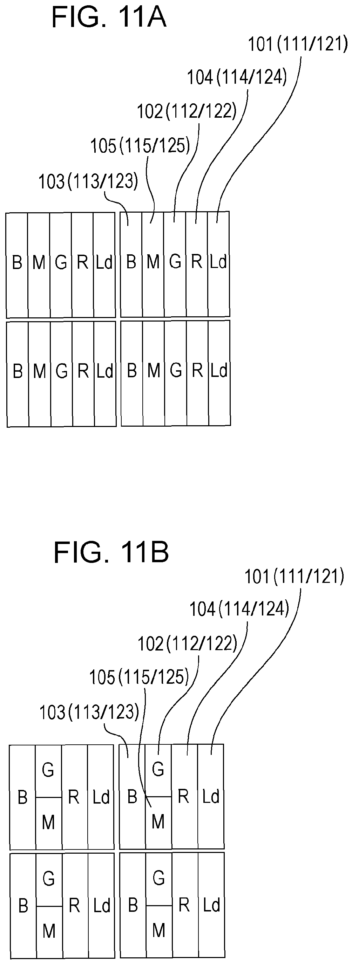

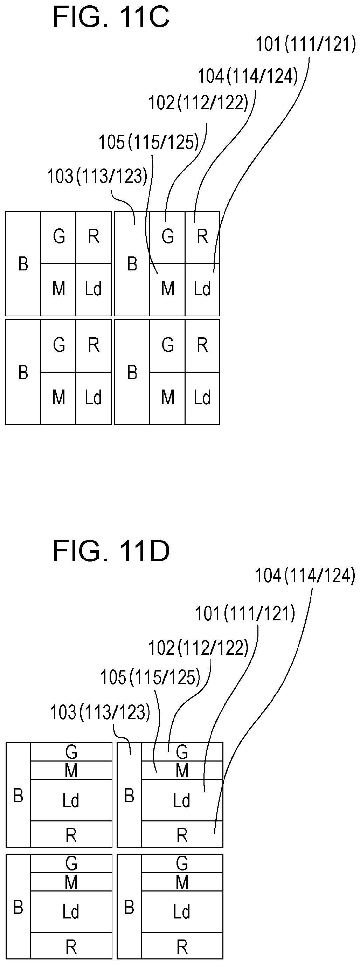

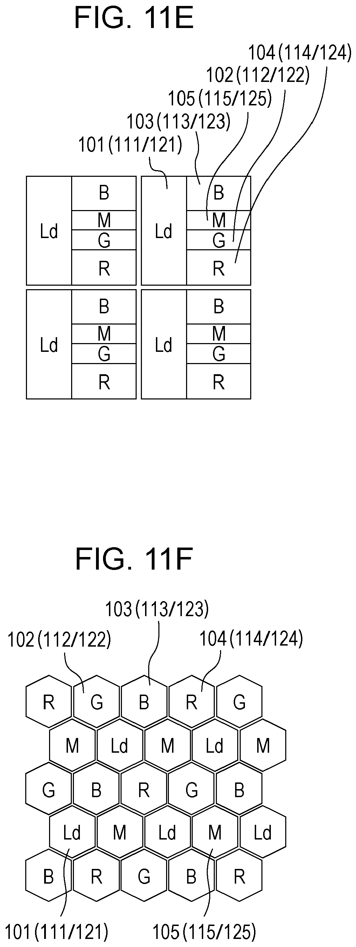

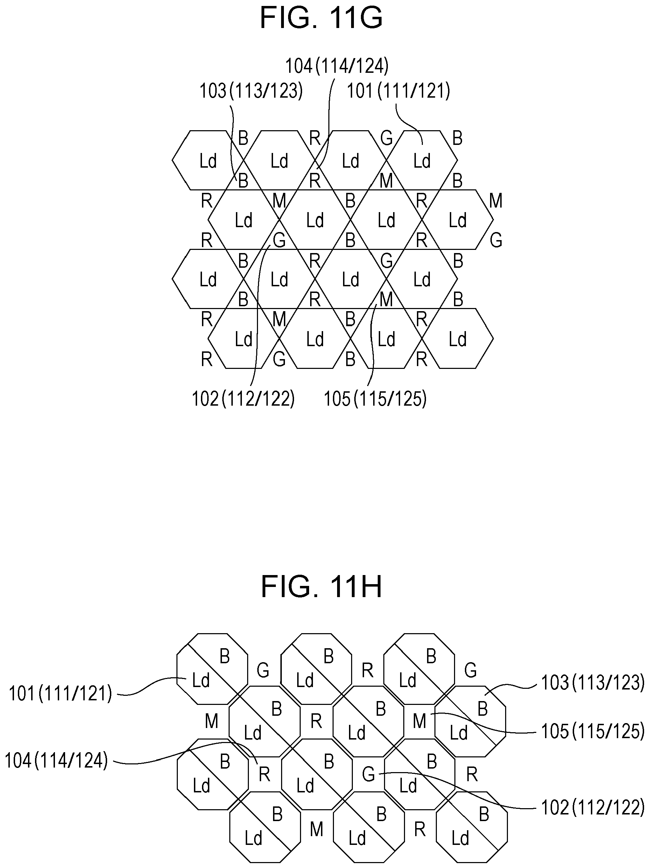

Examples of arrangement patterns of the display unit 100 according to the sixth embodiment are illustrated in Fig. 11A to Fig. 11H. The five types of the display unit 100 include the units 101, 102, 103, 104, and 105. In the sixth embodiment, the arrangement of the display unit 100 may be stripe arrangement, such as that illustrated in Fig. 11A, or may be S-stripe arrangement, such as those illustrated in Fig. 11B to Fig. 11E. The arrangement of the display unit 100 may be delta arrangement, such as those illustrated in Fig. 11F to Fig. 11H, or may be PenTile arrangement (not shown). It is preferable, as illustrated in Fig. 11A to Fig. 11F, that the unit 101 having the spectral characteristic Ld be adjacent to the unit 104 having the spectral characteristic R. To increase the maximum luminance PL of the unit 101 having the spectral characteristic Ld, it is preferable that the area of the unit 101 be relatively large. This makes it possible to stimulate the L cones even in a wavelength region of 650 nm to 700 nm where the sensitivity of the L cones is low. For example, in Fig. 11D, Fig. 11E, and Fig. 11G, the area of the unit 101 having the spectral characteristic Ld is greater than the area of the unit 104 having the spectral characteristic R. It is preferable, as illustrated in Fig. 11A to Fig. 11H, that the unit 105 having the spectral characteristic M be adjacent to the unit 102 having the spectral characteristic Gb. As illustrated in Fig. 11A and Fig. 11B, there may be provided, between the unit 101 having the spectral characteristic Ld and the units 102 and 105 having the spectral characteristics Gb and M, units having other spectral characteristics (e.g., the units 103 and 104 having the spectral characteristics B and R). The unit 101 having the spectral characteristic Ld is not adjacent to the units 102 and 105 having the spectral characteristics Gb and M, and this facilitates distinction between red and green.

The M cones respond not only to light of the unit 102, but also respond sufficiently to light of the unit 105. Therefore, even when, for example, the size of the unit 102 and the unit 105 is reduced to about half the size of the unit 103 as illustrated in Fig. 12B and Fig. 12C, it is still possible to allow the M cones to sufficiently respond. However, since the sensitivity of the L cones is low in the emission region of the unit 101 as in the other embodiments, it is preferable that the size of the unit 101 be greater than those of the other units.

As described above, the display device 1 according to the sixth embodiment includes the five types, the unit 101, the unit 102, the unit 103, the unit 104, and the unit 105, which are independently controlled. This allows efficient and flexible color correction that makes it easier for colorblind persons to distinguish between green and red. Since an image can be displayed by using conventional RGB pixels alone, it is also possible to provide more convenience to persons with normal color vision.

<Seventh Embodiment>

An operation of the display device 1 will now be described as a seventh embodiment. The seventh embodiment is applicable to any of the first to sixth embodiments.

The display device 1 uses a signal RGB including data corresponding to the R value, the G value, and the B value in the RGB color space. When the image signal SIG received by the display device 1 is not the signal RGB including data corresponding to the R value, the G value, and the B value in the RGB color space, for example, the signal SIG for a non-RGB color space, such as the YUV color space, the XYZ color space, or the CMY color space, may be received as an input signal. In this case, the display device 1 may include a converter that converts the signal SIG for the non-RGB color space to the signal RGB for the RGB color space. Examples of the RGB color space include the sRGB color space and the Adobe RGB color space. Examples of the YUV color space include the YCbCr color space and the YPbPr color space. Examples of the CMY color space include the CMYK color space.

On the basis of the signal RGB, the drive unit 60 generates the drive signal DRV suitable for the structure of the element unit 10. In the first to sixth embodiments, the units 101 and 104 each exhibit a luminance corresponding to the R value. The units 102 and 105 each exhibit a luminance corresponding to the G value. The unit 103 exhibits a luminance corresponding to the B value. Since the unit 101 is provided to distinguish red color in the first place, the unit 101 is to be used to display the R channel of the image. Accordingly, the units 101 and 104 each exhibit a luminance corresponding to the R value. Similarly, since the unit 105 is provided to distinguish green color in the first place, the unit 105 is to be used to display the G channel of the image. Accordingly, the units 102 and 105 each exhibit a luminance corresponding to the G value. Then, each of the plurality of units 101 changes in luminance in conjunction with any of the plurality of units 104. Specifically, each of the plurality of units 101 changes in luminance within one second before or after a change in the luminance of any of the plurality of units 104. Each of the plurality of units 101 may change in luminance simultaneously with a change in the luminance of any of the plurality of units 104. Similarly, each of the plurality of units 105 changes in luminance in conjunction with any of the plurality of units 102. Specifically, each of the plurality of units 105 changes in luminance within one second before or after a change in the luminance of any of the plurality of units 102. Each of the plurality of units 102 may change in luminance simultaneously with a change in the luminance of any of the plurality of units 105.

The controller 40 is provided with a database 20 that holds color vision information. The controller 40 has the function of calculating a gain of RGB signals required for correction on the basis of the color vision information in the database 20. Then, the controller 40 generates a correction table of the RGB signals for each color and sends the generated table to the drive unit 60.

The drive unit 60 receives the input signal SIG and adjusts the signal SIG by using the control signal CTRL sent from the controller 40. The drive signal DRV generated by the adjustment is output to the element unit 10. For the drive signal DRV based on the R value, the drive unit 60 can apply different gains to the drive signal DRV for driving the unit 101 and the drive signal DRV for driving the unit 104. For the drive signal DRV based on the G value, the drive unit 60 can apply different gains to the drive signal DRV for driving the unit 102 and the drive signal DRV for driving the unit 105.

The color vision information in the database 20 may include a plurality of patterns. For example, the color vision information may include a first pattern corresponding to normal color vision, a second pattern corresponding to monochromatism, and a third pattern corresponding to dichromatism. The display device 1 receives an instruction signal CLB representing a user's adjustment instruction. On the basis of the instruction signal CLB, one of the plurality of patterns of the color vision information held in the database 20 is selected. On the basis of the pattern selected, the controller 40 generates a correction table for each color and sends the control signal CTLR based on the correction table to the drive unit 60. If the first pattern corresponding to normal color vision is selected as the color vision information held in the database 20, the controller 40 may not send the control signal CTRL and the drive unit 60 may output the drive signal DRV of standard type.

As described above, in the present embodiment, even for a person with monochromatism or dichromatism, a difference in sensitivity between the L cones and the M cones can be easily created by light of the type $\alpha$ unit 101, and a color correction most suitable for each person can be made.

<Eighth Embodiment>

An eighth embodiment is an embodiment that can be combined with the seventh embodiment. The controller 40 may include a color vision testing means 30. The eighth embodiment allows a person to enter the person's own color vision information into the display device 1. The color vision information includes the wavelength sensitivity functions of the L, M, and S cones and the color matching functions of the RGB pixels expected therefrom. The color vision testing means 30 may select newly created color vision information. The display device 1 may include the color vision testing means 30 in the present embodiment. The color vision testing means 30 may be implemented by a hardware circuit or may be implemented by a processor (e.g., MPU, FPGA, or DSP) and software. The color vision testing means 30 may be implemented by a combination of both of the above.

A color vision testing method may be implemented by a program generated on the basis of pseudoisochromatic plates. The pseudoisochromatic plates are plates each depicting a number with a combination of colors that cannot be easily perceived by a colorblind person. A determination of whether the person has normal color vision can be made on the basis of whether the person can read the number correctly. Even if the person cannot read the number, adjusting the gain of the RGB pixels enables the person to correctly read the number in most cases. From the amount of gain adjustment of the RGB pixels performed here, the color vision information of the person can be expected.

The types of color vision tests, including the availability of such a testing function, are not particularly limited. The testing method is also not particularly limited to one that uses the pseudoisochromatic plates, and may be a hue arrangement test.

In the color vision testing method for the display device 1 of the fifth embodiment, when adjustment is made to enable recognition of numbers in the pseudoisochromatic plates, the gain adjustment of the type $\alpha$ unit 101 is added to the adjustment. As an example, Table 2 shows a result of correction of any image that can be obtained by a color vision test for the display device 1 of the fifth embodiment.

[Table 2]

|  | Type $\alpha$ | Type $\beta$ | Type $\gamma$ | Type $\delta$ |
|---|---|---|---|---|
| Normal Color Vision | 0 | 125 | 0 | 150 |
| Monochromatism | 100 | 110 | 0 | 180 |
| Dichromatism | 200 | 115 | 0 | 125 |

If a person has monochromatism, such as that illustrated in Fig. 12B, the amount of response of the L cones to red light is smaller than that in the case of a person with normal color vision. Accordingly, a correction is made to increase the emission intensity of red light. Since an increase in the intensity of emission from the type $\delta$ unit 104 causes an excessive response of the M cones, a correction involving weakening the intensity of emission from the type $\beta$ unit 102 is also made to cancel out the excessive response.

If a person has monochromatism, emission from the type $\delta$ unit 104 does not easily create a difference in the amount of response between the L cones and the M cones. Emission from the type $\alpha$ unit 101 can allow any amount of response from the L cones without causing an excessive response of the M cones. Accordingly, when it is necessary to allow a dominant response of the L cones over the response of the M cones, a correction is made to cause emission from the type $\alpha$ unit 101 at an intensity that allows the L cones to sufficiently respond.

If a person has dichromatism, such as that illustrated in Fig. 12C, since the M cones excessively respond to emission from the type $\delta$ unit 104, a difference in the amount of response between the L cones and the M cones is not easily created. On the other hand, the response of the L cones to emission from the type $\alpha$ unit 101 is dominant over the response of the M cones thereto. Accordingly, when it is necessary to allow a dominant response of the L cones over the response of the M cones, a correction is made to weaken the intensity of emission from the type $\delta$ unit 104 and increase the intensity of emission from the type $\alpha$ unit 101. The sensitivity of the L cones to light in the emission region of the type $\alpha$ unit 101 is considerably lower than that in the emission region of the type $\delta$ unit 104. Accordingly, to weaken the intensity of emission from the type $\delta$ unit 104, the intensity of emission from the type $\alpha$ unit 101 is corrected in such a way that the amount of increase in the intensity of emission from the type $\alpha$ unit 101 is greater than the amount of decrease in the intensity of emission from the type $\delta$ unit 104. Since the M cones excessively respond to emission from the type $\delta$ unit 104, a correction involving weakening the intensity of emission from the type $\beta$ unit 102 is also made to cancel out the excessive response.

From a plurality of results of image correction made as described above, the color vision information of the person is estimated and the amount of gain adjustment for each pixel is determined. In the present example, the types of color vision tests, including the availability of such a testing function, are not particularly limited. The testing method is also not particularly limited to one that uses the pseudoisochromatic plates, and may be a hue arrangement test. Also, the method of gain adjustment for each pixel is not limited to that described above.

The color vision testing method for the display device 1 of the sixth embodiment is not significantly different from the color vision testing method for the display device 1 of the fifth embodiment. However, when adjustment is made to enable recognition of numbers in the pseudoisochromatic plates, the gain adjustment of the type $\varepsilon$ unit 105 is added to the adjustment in the present embodiment. As an example, Table 3 shows a result of correction of any image that can be obtained by a color vision test for the display device 1 of the sixth embodiment.

[Table 3]

|  | Type $\alpha$ | Type $\beta$ | Type $\gamma$ | Type $\delta$ | Type $\varepsilon$ |
|---|---|---|---|---|---|
| Normal Color Vision | 0 | 175 | 90 | 50 | 0 |
| Monochromatism | 60 | 110 | 60 | 60 | 100 |
| Dichromatism | 100 | 175 | 75 | 30 | 50 |

If a person has monochromatism, such as that illustrated in Fig. 12B, since the L cones excessively respond to emission from the type $\beta$ unit 102, a difference in the amount of response between the L cones and the M cones is not easily created. On the other hand, the response of the M cones to emission from the type $\varepsilon$ unit 105 is dominant over the response of the L cones thereto. Accordingly, when it is necessary to allow a dominant response of the M cones over the response of the L cones, a correction is made to weaken the intensity of emission from the type $\beta$ unit 102 and increase the intensity of emission from the type $\varepsilon$ unit 105. However, since emission from the type $\varepsilon$ unit 105 also stimulates the response of the S cones, an additional correction is made which involves weakening the luminance of (or the intensity of emission from) the type $\gamma$ unit 103 to cancel out the response. If a person has monochromatism, the amount of response of the L cones to emission from the type $\delta$ unit 104 is smaller than that in the case of a person with normal color vision. A correction to be made here will not be described, as it is substantially the same as that described in the embodiment.

If a person has dichromatism, such as that illustrated in Fig. 12C, the amount of response of the M cones to emission from the type $\beta$ unit 102 is smaller than that in the case of a person with normal color vision. However, an increase in the intensity of emission from the type $\beta$ unit 102 results in an excessive response of the L cones. Accordingly, the amount of response is corrected by correcting emission from the type $\varepsilon$ unit 105. Since emission from the type $\varepsilon$ unit 105 causes an excessive response of the S cones, a correction involving weakening the luminance of (or the intensity of emission from) the type $\gamma$ unit 103 is also made to cancel out the excessive response. If a person has dichromatism, the amount of response of the M cones to emission from the type $\delta$ unit 104 is more excessive than that in the case of a person with normal color vision. A correction to be made here will not be described, as it is substantially the same as that described in the third embodiment.

From a plurality of results of image correction made as described above, the color vision information of the person is estimated and the amount of gain adjustment for each pixel is determined. In the present example, the types of color vision tests, including the availability of such a testing function, are not particularly limited. The testing method is also not particularly limited to one that uses the pseudoisochromatic plates, and may be a hue arrangement test. Also, the method of gain adjustment for each pixel is not limited to that described above.

Examples

In the present example, a configuration of the display device 1 will be described in which, as illustrated in Fig. 3A, the color filter array 137 of three colors is disposed on the light emitting layer 134 that emits white light by electroluminescence of an organic material. Unlike the element 111 illustrated in Fig. 3A, the element 111 of the present example does not include the wavelength adjuster 139 which is not a color filter. In the element 111 of the present example, the spectral transmittance of the color filter is adjusted to achieve the spectral characteristic described below. The dimension (pixel size) of an element (pixel) serving as a display unit is 1 $\mu$m to 10 $\mu$m, typically about 5 $\mu$m to 10 $\mu$m, and the area of one pixel is 1 $\mu$m$^2$ to 100 $\mu$m$^2$, typically 25 $\mu$m$^2$ to 100 $\mu$m$^2$. In the present example, the pixel size is 7 $\mu$m and the pixel area is about 50 $\mu$m$^2$. As illustrated in Fig. 9D, the pixels of three colors (red, green, and blue) categorized by the colors of the color filters are in a delta arrangement. The diagonal dimension of a display region is typically 0.1 inches (2.54 mm) to 1 inch (25.4 mm), and is 0.5 inches (12.7 mm) in the present example.

An example of the spectral radiance characteristic of the display device 1 is illustrated in Fig. 13B. The spectral radiance characteristic in Fig. 13B is shown as an absolute luminance without being normalized, and the spectral radiance achieved when the display device 1 performs display at the highest level is shown as an absolute luminance without being normalized. That is, the spectral radiance in Fig. 13B is the highest spectral radiance of each of the display units at each wavelength. In the display device 1 of the present example, when all the display units are displayed at the highest integrated radiance and integrated photometric luminance, an integrated photometric luminance of about 500 cd/m$^2$ to 1000 cd/m$^2$ can be achieved. For example, when the specifications of power consumption and product life are changed by changing the design of the display device 1, even an integrated photometric luminance of 1000 cd/m$^2$ to 5000 cd/m$^2$ can be achieved.

The element 111 having a red color filter is the type $\alpha$ unit 101 having a spectral characteristic LR illustrated in Fig. 13B. Since light of the unit 101 at a wavelength of 550 nm or less is almost negligibly weak, the spectral characteristic LR at a wavelength of 550 nm or less is not shown in Fig. 13B. Like the unit 101 described in the third embodiment, the unit 101 exhibits the maximum luminance PL at the wavelength λL in a range of greater than or equal to 650 nm and less than 700 nm. Also, as in the case of the third embodiment, the unit 101 exhibits the maximum luminance PR at the wavelength λR in a range of greater than or equal to 600 nm and less than 650 nm. Thus, the unit 102 exhibits the maximum luminances PR and PL at the wavelengths λR and λL in a range of greater than or equal to 600 nm and less than 700 nm. The maximum luminance PL is higher than the maximum luminance PR and is the highest spectral radiance of visible light exhibited by the unit 101. Accordingly, the peak wavelength of the unit 101 is the wavelength λL and the peak luminance of the unit 101 is the maximum luminance PL. In the present example, the wavelength λL is 660 nm and the wavelength λR is 610 nm. As can be understood from Fig. 13B, the maximum luminance PL and the maximum luminance PR are greater than or equal to 0.01 W/sr/m$^2$/nm. Therefore, it can be understood by referring to Fig. 13A that the maximum luminance PL and the maximum luminance PR are greater than or equal to 0.04 cd/m$^2$ in terms of spectral photometric luminance. Also, the maximum luminance PL and the maximum luminance PR are greater than or equal to 1 cd/m$^2$ in terms of spectral photometric luminance. Although the maximum luminance PL is less than 5 cd/m$^2$ in terms of spectral photometric luminance, the maximum luminance PR is greater than or equal to 5 cd/m$^2$ in terms of spectral photometric luminance. The maximum luminance PL in the present example is 0.021 W/sr/m$^2$/nm, which can be converted by equation (5) to a spectral photometric luminance of 1 cd/m$^2$. The maximum luminance PR in the present example is 0.018 W/sr/m$^2$/nm, which can be converted by equation (5) to a spectral photometric luminance of 6.9 cd/m$^2$. The sum of the spectral photometric luminance at the wavelength λR and the spectral photometric luminance at the wavelength λL is 7.9 cd/m$^2$, and the integrated photometric luminance of the unit 101 including luminances at other wavelengths is greater than or equal to 5 cd/m$^2$ and can be greater than or equal to 5 cd/m$^2$. A comparison between the maximum luminance PL and the maximum luminance PR shows that the maximum luminance PL is higher than the maximum luminance PR in terms of spectral photometric luminance, whereas the maximum luminance PR is higher than the maximum luminance PL in terms of spectral radiance. That is, the peak wavelength of the unit 101 is wavelength λL, the dominant wavelength of the unit 101 is the wavelength λR, and the peak wavelength (wavelength λL) of the unit 101 is longer than the dominant wavelength (wavelength λR) of the unit 101. This means that a person with normal color vision can view the unit 101 as normal red without much feeling of strangeness, and a colorblind person can view the unit 101 as red which can be more clearly distinguished from green.

The element 112 having a green color filter is the type β unit 102 having a spectral characteristic GY illustrated in Fig. 13B. The unit 102 exhibits the maximum luminance PG at the wavelength λG greater than or equal to 500 nm and less than 550 nm. The element 112 also exhibits a maximum luminance PY at the wavelength λY greater than or equal to 550 nm and less than 600 nm. Thus, the element 112 exhibits the maximum luminances PG and PY at the wavelengths λG and λY greater than or equal to 500 nm and less than 600 nm. The maximum luminance PG is higher than the maximum luminance PY and is the highest spectral radiance of visible light exhibited by the unit 102. Accordingly, the peak wavelength of the unit 102 is the wavelength λG and the peak luminance of the unit 102 is the maximum luminance PG. In the present example, the wavelength λG is 525 nm and the wavelength λY is 565 nm. As can be understood from Fig. 13B, the maximum luminance PG and the maximum luminance PY are greater than or equal to 0.01 W/sr/m$^2$/nm. Therefore, it can be understood by referring to Fig. 13A that the maximum luminance PL and the maximum luminance PR are greater than or equal to 0.04 cd/m$^2$ in terms of spectral photometric luminance. Also, the maximum luminance PL and the maximum luminance PR are greater than or equal to 1 cd/m$^2$ and even greater than or equal to 5 cd/m$^2$ in terms of spectral photometric luminance. The maximum luminance PG in the present example is 0.03 W/sr/m$^2$/nm, which can be converted by equation (5) to a spectral photometric luminance of 16 cd/m$^2$. The maximum luminance PY in the present example is 0.01 W/sr/m$^2$/nm, which can be converted by equation (5) to a spectral photometric luminance of 6.8 cd/m$^2$. The sum of the spectral photometric luminance at the wavelength λG and the spectral photometric luminance at the wavelength λY is 22.8 cd/m$^2$, and the integrated photometric luminance of the unit 102 including luminances at other wavelengths is greater than or equal to 5 cd/m$^2$ and can be greater than or equal to 35 cd/m$^2$.

The element 113 having a blue color filter is the type γ unit 103 having the spectral characteristic B illustrated in Fig. 13B. Since light of the unit 103 at a wavelength of 550 nm or more is almost negligibly weak, the spectral characteristic B at a wavelength of 550 nm or more is not shown in Fig. 13B. The unit 103 exhibits the maximum luminance PB at the wavelength λB greater than or equal to 400 nm and less than 500 nm. The wavelength λB is preferably greater than or equal to 400 nm and less than 480 nm. Since the unit 102 does not exhibit a maximum luminance at wavelengths other than the wavelength λB, the peak wavelength of the unit 103 is the wavelength λB and the peak luminance of the unit 103 is the maximum luminance PB. In the present example, the wavelength λB is 455 nm. As can be understood from Fig. 13B, the maximum luminance PB is greater than or equal to 0.01 W/sr/m$^2$/nm. Therefore, it can be understood by referring to Fig. 13A that the maximum luminance B is greater than or equal to 0.04 cd/m$^2$ in terms of spectral photometric luminance. Since the maximum luminance PB is greater than or equal to 0.02 W/sr/m$^2$/nm, the maximum luminance PB is greater than or equal to 1 cd/m$^2$ but less than 5 cd/m$^2$ in terms of spectral photometric luminance. The maximum luminance PG in the present example is 0.035 W/sr/m$^2$/nm, which can be converted by equation (5) to a spectral photometric luminance of 1.7 cd/m$^2$. The sum of the spectral photometric luminance at the wavelength λG and the spectral photometric luminance at the wavelength $\lambda Y$ is 22.8 cd/m$^2$, and the integrated photometric luminance of the unit 101 including luminances at other wavelengths is greater than or equal to 5 cd/m$^2$ and can be greater than or equal to 35 cd/m$^2$.

The relation between the maximum luminances PL, PR, PY, PG, and PB in terms of spectral radiance is expressed as PY < PR < PL < PG < PB, as can be understood from Fig. 13B. Thus, the maximum luminance PL representing the highest spectral radiance of the unit $\alpha$ at the wavelength $\lambda L$ is preferably higher than the maximum luminance PR representing the highest spectral radiance of the unit $\alpha$ at the wavelength $\lambda R$ (PR < PL). The maximum luminance PL representing the highest spectral radiance of the unit $\alpha$ at the wavelength $\lambda L$ is preferably higher than the maximum luminance PY representing the highest spectral radiance of the unit $\beta$ at the wavelength $\lambda Y$ (PY < PL). In the present example, the maximum luminance PL representing the highest spectral radiance of the unit $\alpha$ at the wavelength $\lambda L$ is lower than the maximum luminance PG representing the highest spectral radiance of the unit $\beta$ at the wavelength $\lambda G$ (PL < PG), but it is also preferable that the maximum luminance PL be higher than the maximum luminance PG (PG < PL). In the present example, the maximum luminance PL representing the highest spectral radiance of the unit $\alpha$ at the wavelength $\lambda L$ is lower than the maximum luminance PB representing the highest spectral radiance of the unit $\gamma$ at the wavelength $\lambda B$ (PL < PB), but it is also preferable that the maximum luminance PL be higher than the maximum luminance PB (PB < PL). The maximum luminance PL representing a spectral radiance may be highest of the spectral radiances exhibited by the three units 101, 102, and 103 at the respective peak wavelengths. That is, the relation may be PG < PB < PL or PB < PG < PL. Making the maximum luminance PL in terms of spectral radiance as high as possible is advantageous in allowing a colorblind person to more easily distinguish red color. It is also preferable that the maximum luminance PB representing the highest spectral radiance of the unit $\gamma$ at the wavelength $\lambda B$ be higher than the maximum luminance PG representing the highest spectral radiance of the unit $\beta$ at the wavelength $\lambda G$ (PG < PB). This is because the luminous efficiency for blue light is lower than that for green light. That is, by increasing the spectral radiance of blue light, it is possible to increase the spectral photometric luminance of blue light and provide a desirable color. In the present example, as can be understood from the spectral photometric luminance described above, the relation between the maximum luminances PL, PR, PY, PG, and PB in terms of spectral photometric luminance is PL < PB < PY < PR < PG. The maximum luminance PL representing a spectral photometric luminance may be lowest of the spectral photometric luminances exhibited by the three units 101, 102, and 103 at the respective peak wavelengths. That is, the relation may be PL < PB < PG or PL < PG < PB. Making the maximum luminance PL in terms of spectral photometric luminance as low as possible is advantageous in reducing feeling of strangeness toward colors in the image. As described above, however, the maximum luminance PL for sufficiently stimulating the L cones is greater than or equal to 0.04 cd/m$^2$, preferably greater than or equal to 1 cd/m$^2$, and more preferably greater than or equal to 5 cd/m$^2$ in terms of spectral photometric luminance.

In the present example, where the light emitting layer 134 emitting white light is shared among units of different colors and the color filter array 137 divides the white light into colors, the unit 102 exhibiting green may exhibit a maximum luminance in the vicinity of the wavelength $\lambda R$ at which the unit 102 exhibiting red exhibits the maximum luminance PR. Similarly, the unit 102 exhibiting green may exhibit a maximum luminance in the vicinity of the wavelength $\lambda B$ at which the unit 103 exhibiting blue exhibits the maximum luminance PB. Green may not be distinguished if the unit 102 exhibits a high maximum luminance outside a wavelength range of 500 nm to 600 nm as described above. Accordingly, it is preferable that the luminance exhibited by the unit 102 at the wavelength $\lambda R$ greater than or equal to 600 nm be lower than the luminance exhibited by the unit 101 in the vicinity of the wavelength $\lambda R$. Similarly, it is preferable that the luminance exhibited by the unit 102 at the wavelength $\lambda B$ less than 500 nm be lower than the maximum luminance exhibited by the unit 103 at the wavelength $\lambda B$. Since the luminous efficiency is equal in the comparison between the maximum luminances at the same wavelength, the relation between the spectral photometric luminances and the relation between the spectral radiances are not reversed. Therefore, the comparison described above holds true for both the spectral photometric luminance and the spectral radiance. Similarly, it is preferable that the luminances exhibited by the unit 101 and the unit 103 at the wavelengths $\lambda G$ and $\lambda Y$ be lower than the maximum luminances exhibited by the unit 102 at $\lambda G$ and $\lambda Y$. It is also preferable that the luminances exhibited by the unit 101 and the unit 102 at the wavelength $\lambda B$ be lower than the maximum luminance exhibited by the unit 103 at the wavelength $\lambda B$.

The present invention is not limited to the embodiments described above and various modifications are possible. For example, an example in which a part of the configuration of any of the embodiments is added to another of the embodiments and an example in which a part of the configuration of any of the embodiments is replaced by a part of the configuration of another of the embodiments, are also embodiments of the present invention.

The embodiments described above can be appropriately changed without departing from the scope of the technical ideas. The disclosed content of the present specification includes not only that described in the present specification, but also includes all matters that can be understood from the present specification and the drawings accompanying the present specification. The disclosed content of the present specification includes complements of concepts described in the present specification. That is, for example, if "A is greater than B" is described in the present specification, it can be said that "A is not greater than B" is disclosed without stating that "A is not greater than B". This is because the description "A is greater than B" assumes that "A is not greater than B" is taken into consideration.

The present invention is not limited to the embodiments described above, and various changes and modifications can be made thereto without departing from the spirit and scope of the present invention. The following claims are appended to make the scope of the present invention public.

This application claims the benefit of Japanese Patent Application No. 2019-216772 filed November 29, 2019 and No. 2020-161443 filed September 25, 2020, which are hereby incorporated by reference herein in their entirety.

**Claims**

1. A display device configured to perform display in a plurality of display units by using a light source, wherein

   the plurality of display units include a first type unit and a second type unit;
   a peak wavelength of the first type unit is a first wavelength in a range of greater than or equal to 650 nm and less than or equal to 700 nm;
   a peak wavelength of the second type unit is a second wavelength in a range of greater than or equal to 520 nm and less than 650 nm; and
   the first type unit and the second type unit exhibit a luminance of greater than or equal to 0.04 cd/m$^2$.

2. A display device configured to perform display in a plurality of display units by using an electroluminescent light source, wherein

   the plurality of display units include a first type unit and a second type unit;
   the first type unit exhibits a maximum luminance at a first wavelength in a range of greater than or equal to 650 nm and less than or equal to 700 nm;
   the second type unit exhibits a maximum luminance at a second wavelength in a range of greater than or equal to 500 nm and less than 600 nm; and
   a highest spectral radiance of the first type unit at the first wavelength is higher than a highest spectral radiance of the second type unit at the second wavelength.

3. The display device according to Claim 1 or 2, wherein a luminance exhibited by the first type unit is greater than or equal to 5 cd/m$^2$.

4. The display device according to Claim 1 or 2, wherein the luminance exhibited by the first type unit is greater than or equal to 35 cd/m$^2$.

5. The display device according to any one of Claims 1 to 4, wherein a spectral radiance at the first wavelength is greater than or equal to $0.04/(683*V(kL))$ [W/sr/m$^2$/nm], where $\lambda$L [nm] is the first wavelength and $V(\lambda L)$ is a standard spectral luminous efficiency for photopic vision at the first wavelength.

6. A display device configured to perform display in a plurality of display units by using a light source, wherein

   the plurality of display units include a first type unit and a second type unit having different structures;
   the first type unit exhibits a maximum luminance at a first wavelength in a range of greater than or equal to 650 nm and less than or equal to 700 nm;
   the second type unit exhibits a maximum luminance at a second wavelength in a range of greater than or equal to 480 nm and less than 650 nm;
   the first type unit exhibits a spectral radiance of greater than or equal to $1/(683*V(\lambda L))$ [W/sr/m$^2$/nm] at the first wavelength, where $\lambda$L [nm] is the first wavelength and $V(\lambda L)$ is a standard spectral luminous efficiency for photopic vision at the first wavelength; and
   the second type unit exhibits a spectral radiance of greater than or equal to $5/(683*V(\lambda S))$ [W/sr/m$^2$/nm] at the second wavelength, where $\lambda$S [nm] is the second wavelength and $V(\lambda S)$ is a standard spectral luminous efficiency for photopic vision at the second wavelength.

7. The display device according to any one of Claims 1 to 6, wherein the second wavelength is greater than or equal to 520 nm and less than 550 nm.

8. The display device according to any one of Claims 1 to 7, wherein the second wavelength is a peak wavelength of the second type unit.

9. The display device according to any one of Claims 1 to 8, wherein the first type unit exhibits a maximum luminance at a third wavelength in a range of greater than or equal to 550 nm and less than 650 nm.

10. The display device according to Claim 9, wherein a spectral radiance of the first type unit at the third wavelength is lower than the spectral radiance of the first type unit at the first wavelength.

11. The display device according to any one of Claims 1 to 10, wherein a half width for a spectral radiance of the first type unit at the first wavelength is greater than or equal to 50 nm.

12. The display device according to any one of Claims 1 to 11, wherein the plurality of display units do not include a display unit having a peak wavelength in a range of greater than or equal to 550 nm and less than 650 nm.

13. The display device according to Claim 2 or 6, wherein the first wavelength is a peak wavelength of the first type unit.

14. The display device according to any one of Claims 1 to 8, wherein the plurality of display units include at least one third type unit that exhibits a luminance of greater than or equal to 0.04 cd/m$^2$; and
the third type unit exhibits a maximum luminance at a third wavelength in a range of greater than or equal to 550 nm and less than 650 nm.

15. The display device according to Claim 14, wherein the third wavelength is a peak wavelength of the third type unit.

16. The display device according to Claim 13 or 14, wherein a half width for a spectral radiance of the first type unit at the first wavelength is less than 50 nm.

17. The display device according to any one of Claims 14 to 16, wherein the first type unit changes in luminance within one second before or after a change in the luminance of the third type unit.

18. The display device according to any one of Claims 1 to 15, wherein the plurality of display units include at least one fourth type unit that exhibits a luminance of greater than or equal to 0.04 cd/m$^2$; and
the fourth type unit exhibits a maximum luminance at a fourth wavelength in a range of greater than or equal to 480 nm and less than 520 nm.

19. The display device according to Claim 17, wherein the fourth wavelength is a peak wavelength of the fourth type unit.

20. The display device according to Claim 17 or 18, wherein the luminance exhibited by the fourth type unit is greater than or equal to 5 cd/m$^2$.

21. The display device according to any one of Claims 1 to 18, wherein the plurality of display units include at least one fifth type unit that exhibits a luminance of greater than or equal to 0.04 cd/m$^2$; and
the fifth type unit exhibits a maximum luminance at a fifth wavelength in a range of greater than or equal to 400 nm and less than 480 nm.

22. The display device according to any one of Claims 1 to 21, wherein the peak wavelength and a dominant wavelength of the first type unit differ from each other.

23. The display device according to any one of Claims 1 to 21, wherein the display device receives a signal including data corresponding to an R value, a G value, and a B value in an RGB color space, and the first type unit exhibits a luminance corresponding to the R value.

24. The display device according to any one of Claims 1 to 23, wherein the first type unit includes a portion that emits light by electroluminescence.

25. The display device according to any one of Claims 1 to 24, wherein of the plurality of elements, an element corresponding to the first type unit includes a first color filter, and of the plurality of elements, an element corresponding to the second type unit includes a second color filter that differs in transmission characteristic from the first color filter.

26. The display device according to any one of Claims 1 to 25, wherein the first type unit includes a portion that emits light by photoluminescence.

27. An apparatus comprising:

the display device according to any one of Claims 1 to 26; and
a signal generating device configured to generate a signal to be received by the display device.

28. An apparatus comprising:

the display device according to any one of Claims 1 to 26; and
an image pickup device configured to take an image to be displayed by the display device.

29. The apparatus according to Claim 27 or 28, wherein the apparatus is a wearable apparatus.

30. The apparatus according to Claim 27, wherein the apparatus is any one of an electronic board, a traffic light machine, and an in-vehicle indicator.

FIG. 1A

FIG. 1B

FIG. 1C

FIG. 2A

SPECTRAL PHOTOMETRIC LUMINANCE (cd/m²/nm)

SPECTRAL RADIANCE (W/sr/m²/nm)

FIG. 2B

SPECTRAL PHOTOMETRIC LUMINANCE (cd/m²/nm)

SPECTRAL RADIANCE (W/sr/m²/nm)

# FIG. 3A

# FIG. 3B

# FIG. 3C

# FIG. 3D

# FIG. 4

FIG. 5A

102(112/122)
103(113/123) 101(111/121)

| B | G | La | B | G | La |
| B | G | La | B | G | La |

FIG. 5B

101(111/121)
103(113/123) 102(112/122)

FIG. 5C

101(111/121) 102(112/122) 103(113/123)

# FIG. 5D

101(111/121)    103(113/123)
102(112/122)

# FIG. 5E

101(111/121)    102(112/122)
103(113/123)

# FIG. 6A

# FIG. 6B

# FIG. 6C

# FIG. 7

# FIG. 8

FIG. 9A

102(112/122)    101(111/121)

103(113/123)    104(114/124)

| B | M | R | Ld | B | M | R | Ld |
|---|---|---|----|---|---|---|----|
| B | M | R | Ld | B | M | R | Ld |

FIG. 9B

102(112/122)    101(111/121)

103(113/123)    104(114/124)

| | M | | M |
|---|---|---|---|
| B | Ld | B | Ld |
| | R | | R |
| | M | | M |
| B | Ld | B | Ld |
| | R | | R |

FIG. 9C

103(113/123)    102(112/122)

101(111/121)    104(114/124)

| | B | | B |
|---|---|---|---|
| Ld | M | Ld | M |
| | R | | R |
| | B | | B |
| Ld | M | Ld | M |
| | R | | R |

FIG. 9D

| B | M | R | Ld | B |
| R | Ld | B | M | R |
| Ld | B | M | R | Ld |
| M | R | Ld | B | M |
| R | Ld | B | M | R |

101(111/121)   103(113/123)

104(114/124)   102(112/122)

FIG. 9E

101(111/121)

103(113/123)

102(112/122)        104(114/124)

FIG. 9F

104(114/124)        102(112/122)

101(111/121)        103(113/123)

# FIG. 10

## FIG. 11A

101 (111/121)

104 (114/124)

102 (112/122)

105 (115/125)

103 (113/123)

| B | M | G | R | Ld | B | M | G | R | Ld |
|---|---|---|---|----|---|---|---|---|----|

| B | M | G | R | Ld | B | M | G | R | Ld |
|---|---|---|---|----|---|---|---|---|----|

## FIG. 11B

101 (111/121)

104 (114/124)

102 (112/122)

105 (115/125)

103 (113/123)

## FIG. 11C

101 (111/121)

104 (114/124)

102 (112/122)

105 (115/125)

103 (113/123)

## FIG. 11D

104 (114/124)

101 (111/121)

102 (112/122)

105 (115/125)

103 (113/123)

# FIG. 11E

104(114/124)
102(112/122)
105(115/125)
103(113/123)
101(111/121)

| Ld | B |
|    | M |
|    | G |
|    | R |

| Ld | B |
|    | M |
|    | G |
|    | R |

| Ld | B |
|    | M |
|    | G |
|    | R |

| Ld | B |
|    | M |
|    | G |
|    | R |

# FIG. 11F

103(113/123)

102(112/122)          104(114/124)

R G B R G

M Ld M Ld M

G B R G B

Ld M Ld M Ld

B R G B R

101(111/121)          105(115/125)

# FIG. 11G

104 (114/124)

103 (113/123)      101 (111/121)

102 (112/122)      105 (115/125)

# FIG. 11H

101 (111/121)

104 (114/124)

103 (113/123)

105 (115/125)

102 (112/122)

## FIG. 12A

## FIG. 12B

# FIG. 12C

# FIG. 12D

# FIG. 13A

— 0.04/(683*V(λ))  — 1/(683*V(λ))  — 5/683*(V(λ))  ·····V(λ)

# FIG. 13B

**INTERNATIONAL SEARCH REPORT**

| | International application No. |
| --- | --- |
| | PCT/JP2020/043558 |

A. CLASSIFICATION OF SUBJECT MATTER
Int.Cl. G02B5/20(2006.01)i, G09F9/00(2006.01)i, G09F9/30(2006.01)i,
G09F9/302(2006.01)i, G09F9/33(2006.01)i, H01L27/32(2006.01)i,
H04N9/30(2006.01)i, H05B33/12(2006.01)i, H01L51/50(2006.01)i,
H05B33/14(2006.01)i
FI: G09F9/302C, G09F9/30365, G09F9/00313, H05B33/14A, H05B33/14Z, H05B33/12E,
H01L27/32, H05B33/12B, G02B5/20101, G09F9/33, H04N9/30
According to International Patent Classification (IPC) or to both national classification and IPC

B. FIELDS SEARCHED

Minimum documentation searched (classification system followed by classification symbols)
Int.Cl. G02B5/20, G09F9/00, G09F9/30, G09F9/302, G09F9/33, H01L27/32,
H04N9/30, H05B33/12, H01L51/50, H05B33/14

Documentation searched other than minimum documentation to the extent that such documents are included in the fields searched
Published examined utility model applications of Japan          1922-1996
Published unexamined utility model applications of Japan        1971-2021
Registered utility model specifications of Japan                1996-2021
Published registered utility model applications of Japan        1994-2021

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X | JP 2016-057621 A (SAMSUNG DISPLAY CO., LTD.) 21 April 2016 (2016-04-21), paragraphs [0006]-[0028], | 1-8, 11-13, 18-30 |
| Y | [0030]-[0099], fig. 1, 2 | 9-10, 14-17 |
| Y | JP 2007-095447 A (SHARP CORPORATION) 12 April 2007 (2007-04-12), paragraphs [0047]-[0051], fig. 10 | 9-10, 14-17 |
| A | WO 2011/039811 A1 (NEC DISPLAY SOLUTIONS LTD.) 07 April 2011 (2011-04-07), entire text, all drawings | 1-30 |
| A | JP 2006-013905 A (FUNAI ELECTRIC CO., LTD.) 12 January 2006 (2006-01-12), entire text, all drawings | 1-30 |

☒ Further documents are listed in the continuation of Box C.  ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
| --- | --- |
| 20 January 2021 | 02 February 2021 |

| Name and mailing address of the ISA/ | Authorized officer |
| --- | --- |
| Japan Patent Office 3-4-3, Kasumigaseki, Chiyoda-ku, Tokyo 100-8915, Japan | Telephone No. |

Form PCT/ISA/210 (second sheet) (January 2015)

**INTERNATIONAL SEARCH REPORT**

| International application No. |
|---|
| PCT/JP2020/043558 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2001-508889 A (NEDERLANDSE ORGANISATIE VOOR TOEGEPAST-NATUURWETENSCHAPPELIJK ONDERZOEK TNO) 03 July 2001 (2001-07-03), entire text, all drawings | 1-30 |
| A | JP 2005-524154 A (ELECTRONICS AND TELECOMMUNICATIONS RESEARCH INSTITUTE) 11 August 2005 (2005-08-11), entire text, all drawings | 1-30 |

Form PCT/ISA/210 (second sheet) (January 2015)

**INTERNATIONAL SEARCH REPORT**
Information on patent family members

International application No.

PCT/JP2020/043558

| | | |
|---|---|---|
| JP 2016-057621 A | 21 April 2016 | US 2016/0071470 A1<br>paragraphs [0008]-[0025],<br>[0035]-[0113], fig. 1, 2<br>EP 2993664 A2<br>KR 10-2016-0030005 A<br>CN 105405380 A<br>TW 201610976 A |
| JP 2007-095447 A | 12 April 2007 | (Family: none) |
| WO 2011/039811 A1 | 07 April 2011 | (Family: none) |
| JP 2006-013905 A | 12 January 2006 | (Family: none) |
| JP 2001-508889 A | 03 July 2001 | US 6362830 B1<br>entire text, all drawings |
| JP 2005-524154 A | 11 August 2005 | US 2005/0105796 A1<br>entire text, all drawings |

Form PCT/ISA/210 (patent family annex) (January 2015)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014174361 A
- JP 2003304508 A
- JP 2013505009 W
- JP 2016196611 A
- JP 2016 A
- JP 79213 A
- JP 2013001877 A
- JP 2008 A
- JP 274165 A
- JP 2019216772 A
- JP 2020161443 A